(19) **Europäisches Patentamt**

**European Patent Office**

**Office européen des brevets**

(11) **EP 0 896 432 B1**

(12) **EUROPEAN PATENT SPECIFICATION**

(45) Date of publication and mention
of the grant of the patent:
**23.07.2003 Bulletin 2003/30**

(51) Int Cl.⁷: **H03K 5/13**

(21) Application number: **98109781.9**

(22) Date of filing: **28.05.1998**

(54) **Synchronous delay circuit**

Synchrone Verzögerungsschaltung

Circuit de retard synchrone

(84) Designated Contracting States:
**DE FR GB**

(30) Priority: **30.05.1997 JP 15797497**
**08.05.1998 JP 14223498**

(43) Date of publication of application:
**10.02.1999 Bulletin 1999/06**

(73) Proprietor: **NEC Electronics Corporation**
**Kawasaki, Kanagawa 211-8668 (JP)**

(72) Inventor: **Saeki, Takanori**
**Minato-ku, Tokyo (JP)**

(74) Representative: **Glawe, Delfs, Moll & Partner**
**Patentanwälte**
**Postfach 26 01 62**
**80058 München (DE)**

(56) References cited:
**EP-A- 0 720 291      EP-A- 0 829 964**

**Description**

This invention relates to a semiconductor integrated circuit and, more particularly, to a synchronous delay circuit for controlling a clock signal.

Owing to their circuit simplicity and small current consumption, synchronous delay circuits that eliminate clock skew in a short synchronization time find use in high-speed clock synchronizing circuits. Reference may be made to the following literature describing such synchronous delay circuits:

(1) Japanese Patent Kokai publicaiton No. JP-A-8-237091;
(2) "Skew Minimization Technique for 256 M-bit Synchronous DRAM and Beyond", by Jin-Man Han, et al., 1996 Symp. on VLSI Circ., pp. 192 ∼ 193;
(3) "Clock Buffer Chip with Absolute Delay Regulation Over Process and Environment Variations", by Richard B. Watson et al., Proc. of IEEE 1992 CICC (Custom Integrated Circuits Conference), 25.2; and
(4) "Digital Delay Locked Loop and Design Technique for High-Speed Synchronous Interface", IEICE TRANS. ELECTRON., VOL. E79-C, No. 6, June, 1996, pp. 798 ∼ 807.

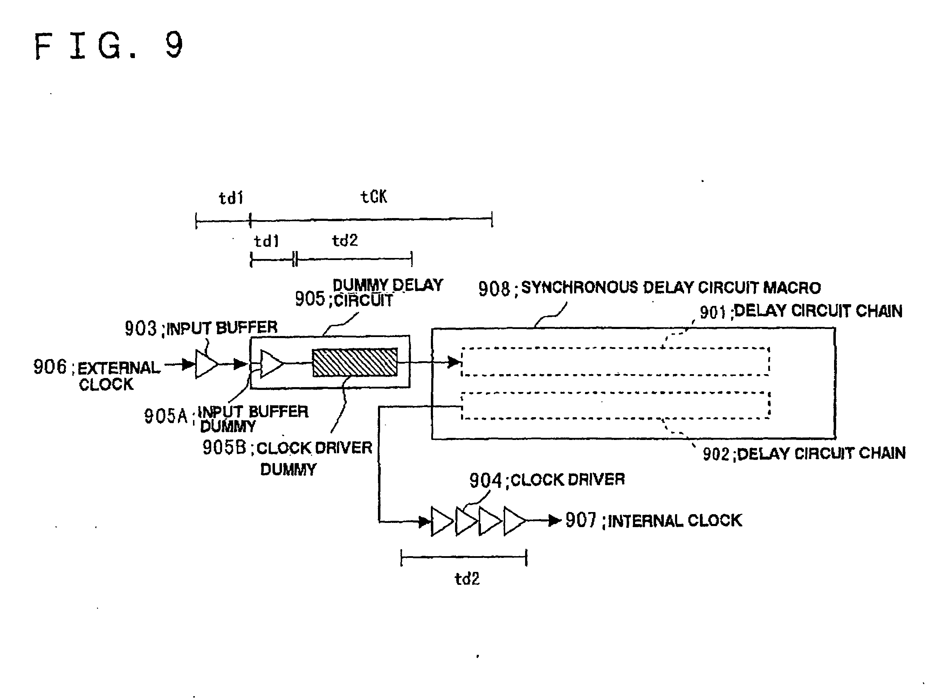

As shown in Fig. 9, a synchronous delay circuit basically comprises a delay circuit 901 used to measure a fixed time difference, a delay circuit 902 for reconstructing the measured delay time, and a dummy delay circuit 905 having a delay time corresponding to delay times td1 + td2 obtained by adding delay times td1, td2 of an input buffer 903 and clock driver 904.

In order to make the delay time equal to the delay times td1, td2 of the input buffer 903 and clock driver 904, there are many cases where the dummy delay circuit 905 is composed of an input buffer dummy 905A, which uses circuitry exactly the same as that of the input buffer, and a clock driver dummy 905B.

The delay circuits 901 and 902 are constituted by delay circuit chains having equal delay times and for this reason are also referred to as delay circuit chains.

The purpose of the delay circuits 901 and 902 is to measure a fixed period of time (this is the function of circuit 901) and reconstruct this period of time (this is the function of circuit 902). This purpose can be attained by causing a signal to advance through the delay circuit 901 and arrange it so that a number of delay elements equal to the number of delay elements through which the signal passed in the delay circuit 901 will be traversed by the signal in the delay circuit 902.

Methods of arranging it so that a number of delay elements equal to the number of delay elements through which the signal passed in the delay circuit 901 will be traversed by the signal in the delay circuit 902 can be divided into two categories depending upon the propagation directions of the delay circuits 901 and 902 and into two categories depending upon whether the end is selected or the overall path in order to decide the length of the delay circuit 902. There are four types in each of the two categories.

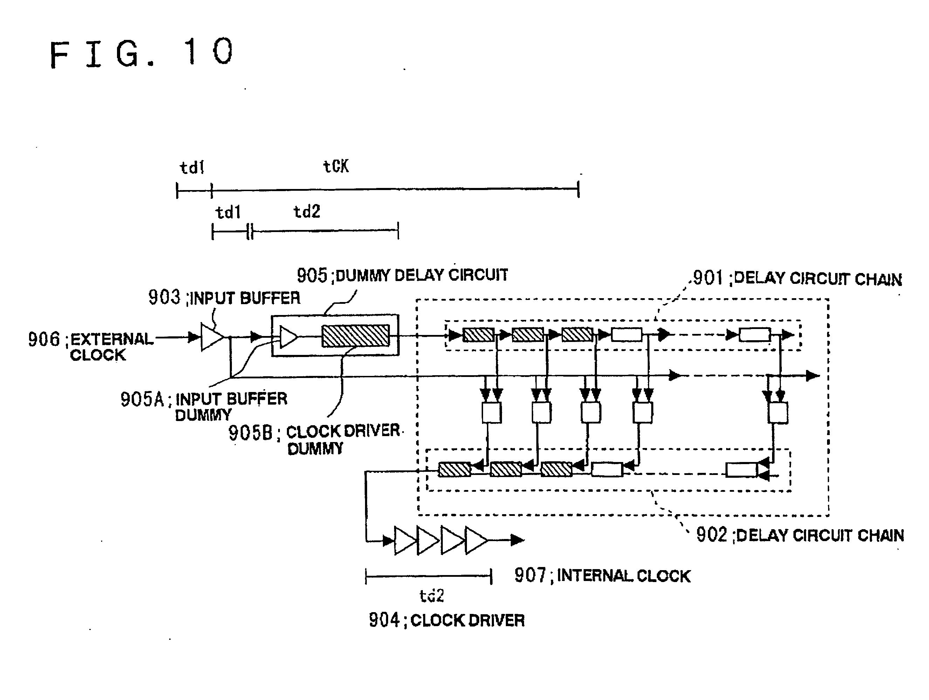

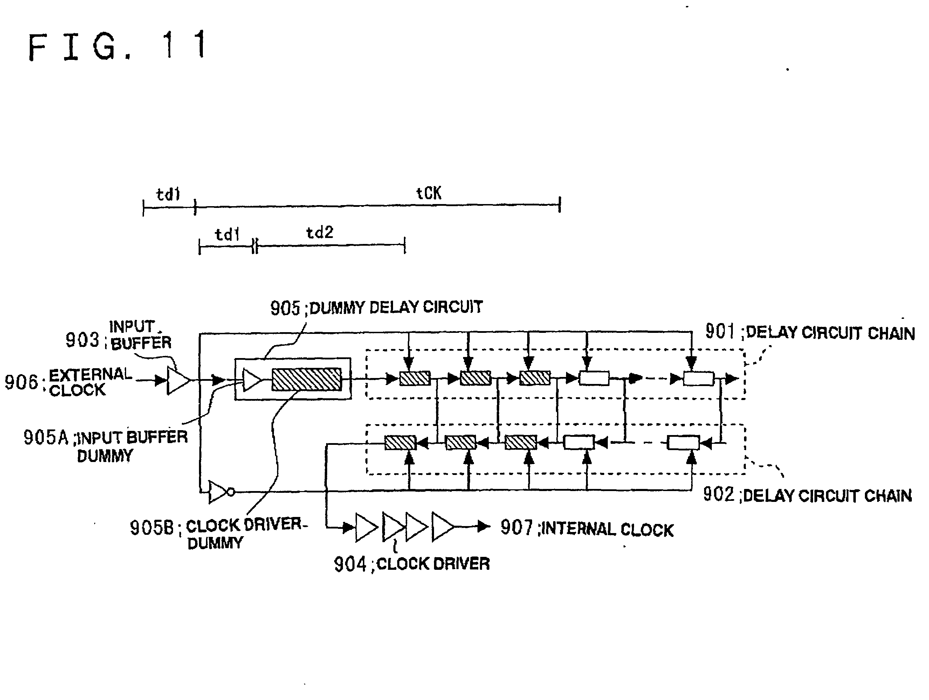

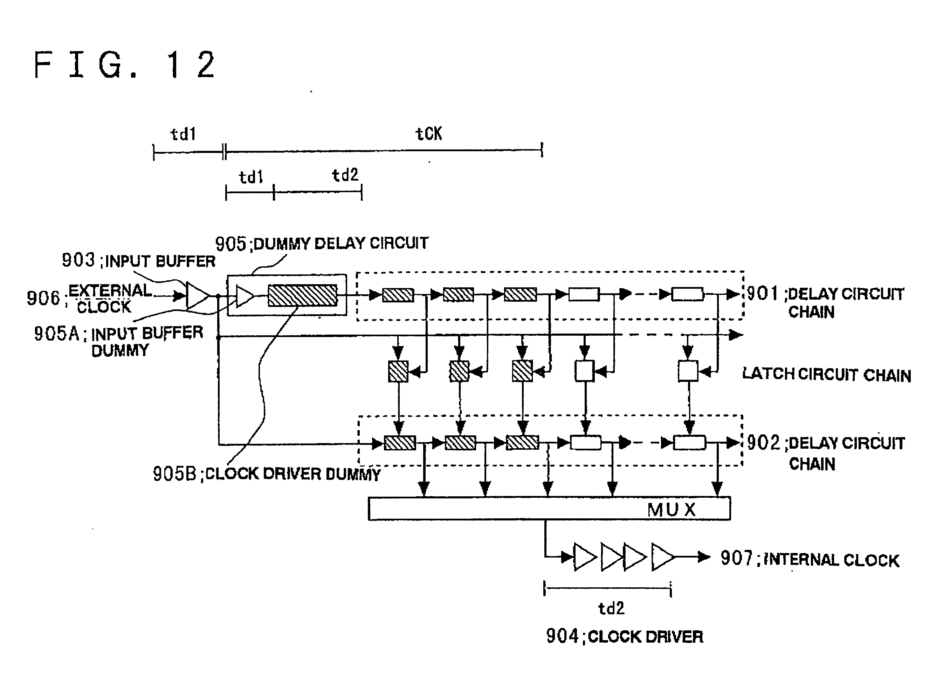

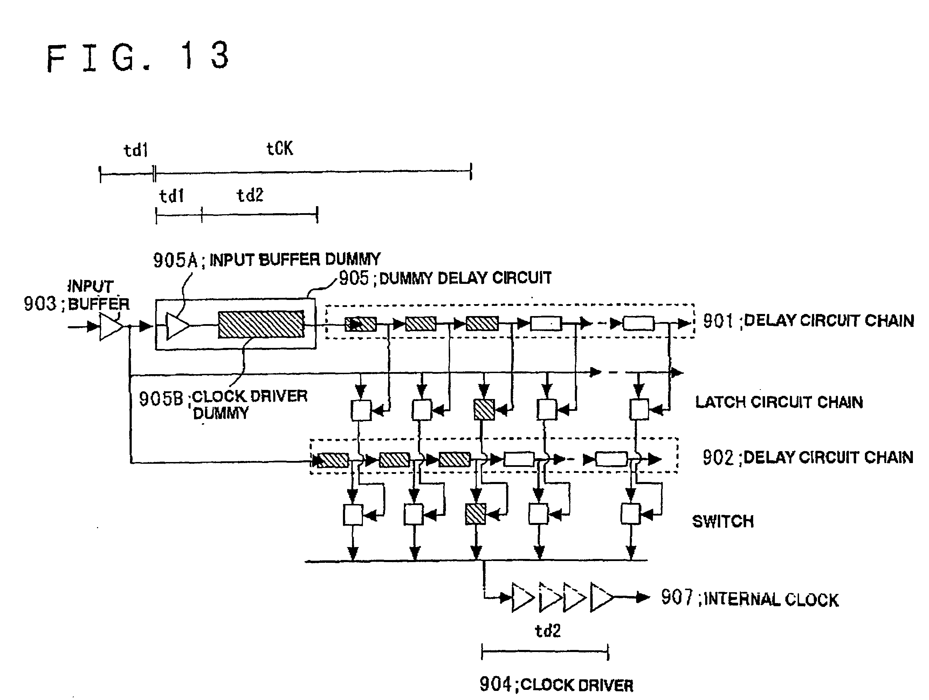

More specifically, if the methods are classified depending upon the propagation directions of the delay circuits 901 and 902, there are the types shown in Figs. 12 and 13 in which the propagation directions of the delay circuits 901 and 902 are the same and length is decided on the output terminal side of the delay circuit 902 in order to decide the number of elements in the delay circuit 902, and there are the types shown in Figs. 10 and 11 in which the propagation directions of the delay circuits 901 and 902 are opposite each other and length is decided on the input terminal side of the delay circuit 902 in order to decide the number of elements in the delay circuit 902.

If the methods are classified depending upon whether the end is selected or the overall path in order to decide the length of the delay circuit 902, there are the methods shown in Figs. 10 and 13 in which the end is selected and the methods shown in Figs. 11 and 12 in which the overall path is selected.

Fig. 10 corresponds to the scheme described in the above-mentioned Japanese Patent Application Laid-Open No. 8-237091 field by the present inventor which document corresponds to EP-A-0720291 and forms the basis of the preamble of claim 1.

Fig. 11 corresponds to the scheme described in the above-mentioned literature (4) (IEICE TRANS. ELECTRON., VOL. E79-C, No. 6, June, 1996, pp. 798 ∼ 807).

Fig. 12 corresponds to the scheme described in the above-mentioned literature (2) (1996 Symp. on VLSI Circ., pp. 192 ∼ 193).

Fig. 13 corresponds to the scheme described in the above-mentioned literature (3) (Proc. of IEEE 1992 CICC 25.2) and in the above-mentioned literature (2) (1996 Symp. on VLSI Circ., pp. 112 ∼ 113).

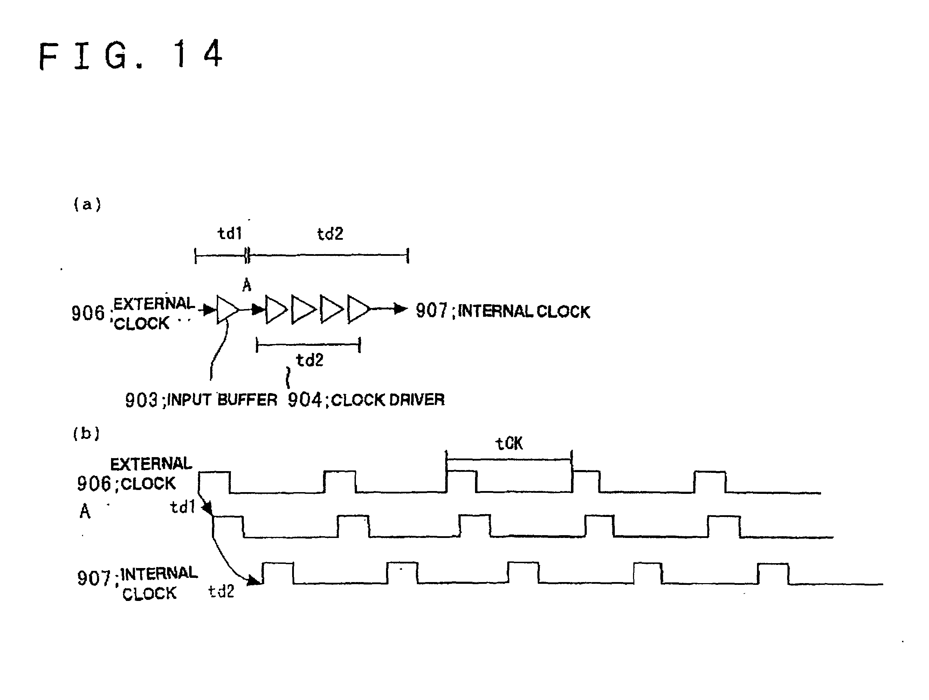

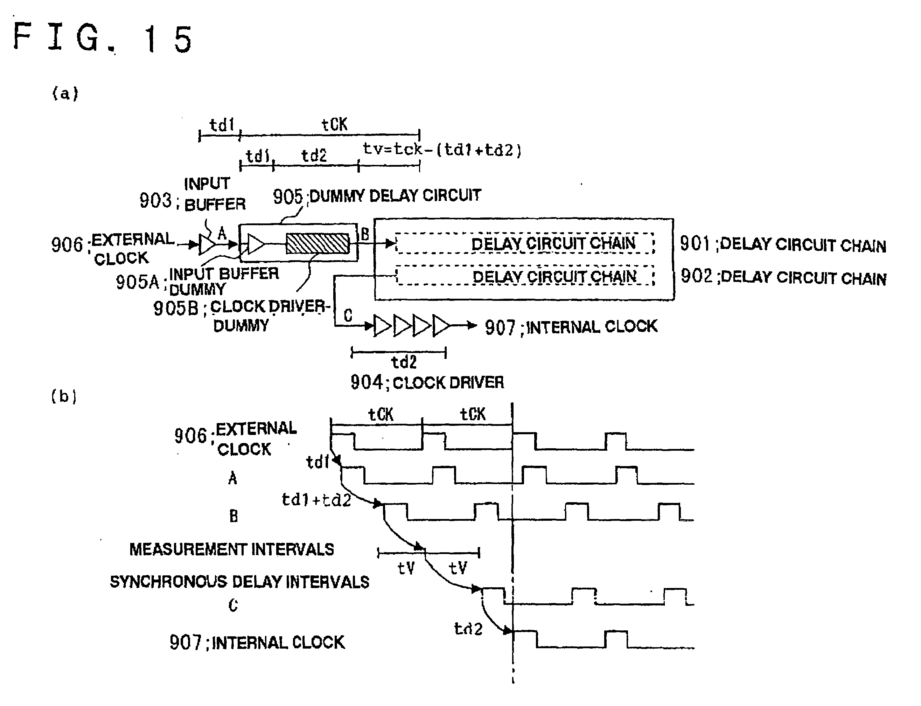

Operations through which clock skew is eliminated will be described with reference to the schematic views and timing charts of Figs. 14 and 15.

(1) Clock delay when synchronous delay circuit is not used

Fig. 14 illustrates a case in which a synchronous delay circuit is not used. As shown in Fig. 14(a), an external clock 906 is utilized as an internal clock 907 supplied to the internal circuitry of a semiconductor integrated circuit device through the input buffer 903 and the clock driver 904. The delay time between the external clock 906 and the internal clock 907 is decided by the delay time td1 of the input buffer 903 and the delay time td2 of the clock driver 904. The sum td1 + td2 is clock skew.

(2) Principle of clock delay elimination when synchronous delay circuit is used

A synchronous delay circuit utilizes the fact that a clock pulse enters at a clock period tCK to effectively eliminate clock skew. That is, a delay circuit having a delay time of

$$tCK - (td1 + td2)$$

is provided and disposed between the input buffer (delay time td1) and the clock driver (delay time td2) so that the sum of the delay times will be made equal to the clock period tCK [= td1 + tCK - (td1 + td2) + td2].

As a result, the timing of the internal clock output by the clock driver becomes equal to the timing of the external clock.

(3) Method of clock delay elimination when synchronous delay circuit is used

Fig. 15(b) shows a timing chart for a case in which a synchronous delay circuit is actually used.

The operation of a synchronous delay circuit requires two periods.

The first period is used to measure the delay time tCK - (td1 + td2) dependent upon the clock period and to decide the delay length of the delay circuit that reconstructs the delay tCK - (td1 + td2).

The next period is used for the amount of delay of tCK - (td1 + td2).

With regard to the first period, the dummy delay circuit 905 of the clock driver 904 and the delay circuit chain 901 are used to measure the delay time tCK - (td1 + td2) dependent upon the clock period.

The output of input buffer 903 resulting from the first pulse of two consecutive pulses of external clock 906 is caused to advance through dummy delay circuit 905 and delay circuit 901 in one clock period tCK, which extends up to output of the second pulse from the input buffer 903. Since the delay time of the dummy delay circuit 905 is td1 + td2, the time needed for a pulse to advance through the delay circuit 901 is tCK - (td1 + td2).

The delay time of the delay circuit 902 is set to be equal to the time tCK - (td1 + td2) that was required for the pulse to advance through the delay circuit 901.

Though this method of setting the delay circuit 902 can be classified broadly into the four types mentioned above, each is capable of attaining the desired object.

With regard to the next period, a clock pulse that has been output by the input buffer 903 passes through the delay circuit 902 whose delay is tCK - (td1 + td2) and is output by the clock driver 904 to thereby produce the internal clock 907 whose delay is exactly equal to the clock cycle tCK.

The process described above provides the internal clock 907, which is free of clock skew, in two clock periods.

Meanwhile, in a synchronous delay circuit adapted for removing clock skew in a shorter synchronous period, there has already been proposed a system configured not only for eliminating skew but also for doubling the clock frequency or generating 50% duty (Duty50) shown for example in JP Patent Kokai JP-A-8-237091 of the above publication [1] by the inventors hereof.

Similarly to the skew eliminating configuration, the circuit for doubling the clock frequency ( frequency doubling circuit) and for generating Duty50 is made up of paired delay circuits, namely a delay circuit for measuring a pre-set time difference and a delay circuit for reproducing the delay time, and is configured for doubling the delay time of the delay circuit for reproducing the delay time to a speed twice as high as that of the delay circuit for measuring the pre-set time difference. In actuality, the circuit for doubling the clock frequency and for generating Duty50 is frequently used in combination with the skew eliminating circuit.

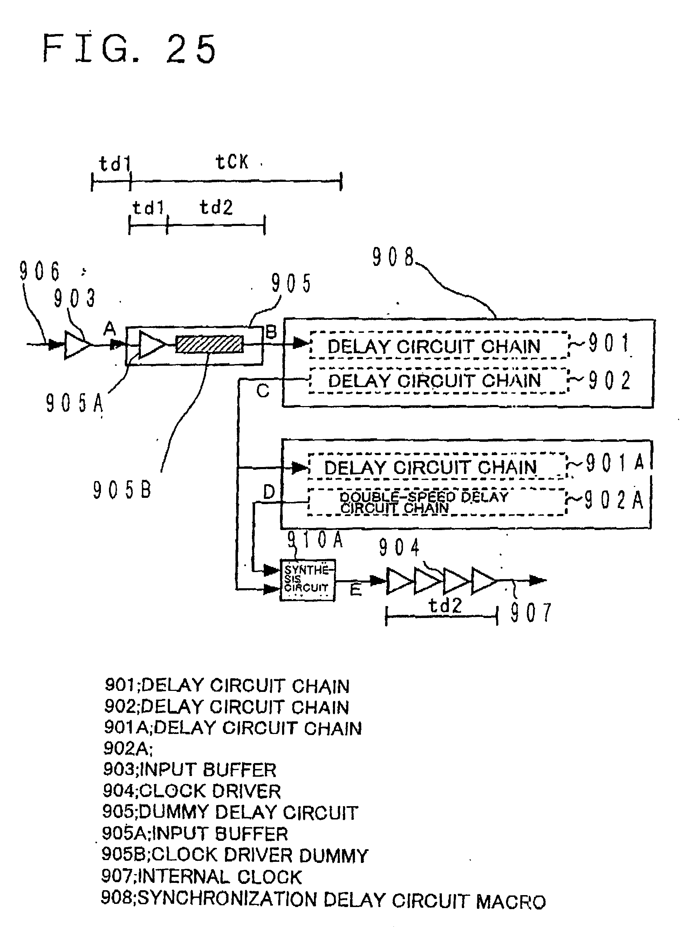

Fig.25 shows an example of a basic configuration of a synchronous delay circuit. Referring to Fig. 25, this conventional synchronous delay circuit is a conventional synchronous delay circuit, explained with reference to Fig.9, to which are annexed a pair of delay circuit chain. That is, the synchronous delay circuit shown in Fig.25 further comprises a pair of delay circuit chains, made up of a delay circuit chain 901 for measuring the clock period, and a delay circuit chain 902 for reproducing the measured delay time, and a pair of delay circuit chains, made up of a delay circuit chain 901A for measuring the pre-set time difference and a delay circuit chain 902A for reproducing the measured delay time (speed-doubling delay circuit chain), with the two pairs of the delay circuit chains being connected in series with each other. An output of the delay circuit chain 902 and an output of the speed-doubling delay circuit chain 902A are synthesized by a synthesis circuit 910A so as to be supplied to a clock driver 904 with delay time td2.

This double frequency generating and Duty50 generating circuit may be classified similarly to the skew removing circuit.

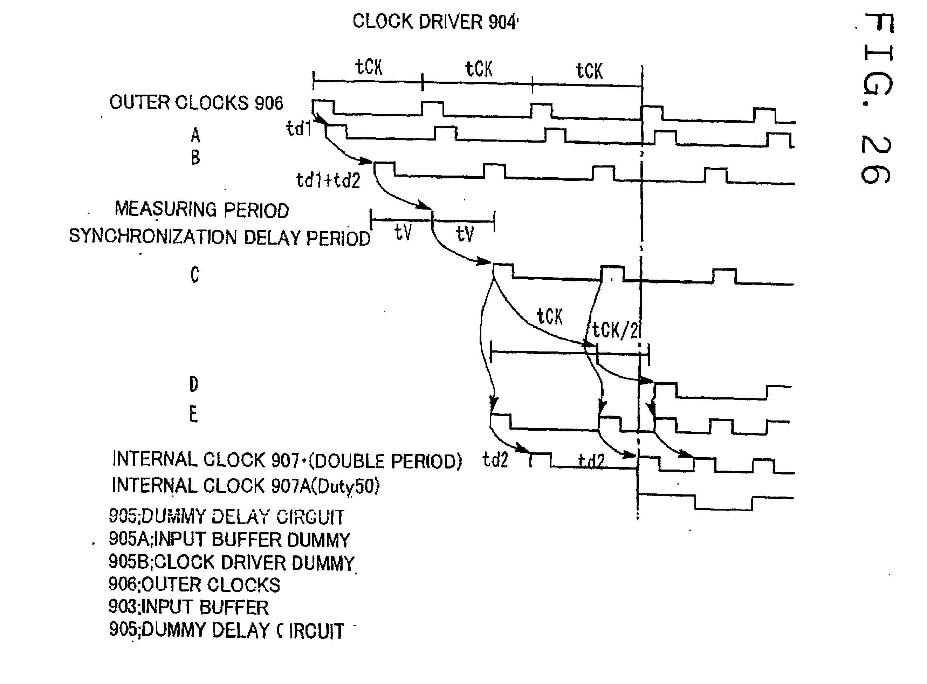

The operation of the double frequency generating and Duty50 generating circuit is explained with reference to a timing chart shown in Fig.26.

(2) Principle of Clock Delay Removal in Case of Using the Synchronous Delay Circuit

For generating the double frequency and Duty50, the synchronous delay circuit utilizes the properties of the clock pulses being entered every clock period tCK. That is, a delay circuit chain (902A of Fig.25) with a delay time of tCK/2 is provided and the delay time with respect to the pre-input clock is set so as to be equal to one-half the clock period tCK. The clock signals so set are then synthesized with the original clock signals (output C of the delay circuit chain 902 of Fig.25) to provide the double frequency (E of Fig.25) or Duty50%.

(3) Method for Removing Clock Delay in Case of using the Synchronous Delay Circuit

The timing operation in case of using the synchronous delay circuit is explained with reference to Fig. 26, which shows a timing chart representing the waveform of each node of Fig.25.

The operation of the synchronous delay circuit for double frequency generation and Duty50 generation is in need of 1.5 periods.

The first one period is used for measuring the delay time tCK which depends on the clock period and for determining the delay length of the delay time adapted for reproducing the delay amount of tCK/2. The next period is used for the delay amount of tCK/2.

In measuring the clock-period-dependent delay time tCK for the first period, a delay circuit chain 901A is used. An output of the first pulse delay circuit chain 902 for the first one of two consecutive pulses of the clocks 906 (C of Figs.25 and 26) proceeds through the delay circuit chain 901A during one clock period tCK until outputting of the second delay circuit chain 902. That is, the time during which the pulse proceeds through the delay circuit chain 901A represents the clock period tCK.

The delay time of the delay circuit chain 902A is set so as to be equal to one-half tCK which is the time during which the pulse proceeded through the delay circuit chain 901A.

The methods for setting the delay time of the delay circuit chain 902A are roughly classified into four according to desired objectives to be achieved.

During the next period, the clocks exiting the delay circuit chain 901A are output through the delay circuit chain 902A having the delay quantity equal to tCK/2 (signal D of Figs.25 and 26) so as to be synthesized with the clock exiting the delay circuit chain 902 (signal C of Figs.25 and 26) and output to generate internal clocks 907 of the double frequency and internal clocks of the Duty50 (907A of Fig.26).

By the above process, two clock periods for clock skew removal and 1.5 periods for double frequency and Duty50, totaling at 3.5 periods, provide internal clock double frequency free of clock skew and clocks of Duty50 are produced.

However, this conventional synchronous delay circuit execute clock skew removal and frequency doubling- Duty50 with two clock periods and with 1.5 periods, respectively, thus requiring 3.5 clocks (3.5 tCK) as the time required for skew removal.

Thus, the problem is raised that, by adding the function of Duty50 and double frequency, it is not possible to exploit the merit proper to the circuit sufficiently.

Since the amount of dummy delay of the clock is fixed in the synchronous delay circuit of the prior art described above, it is necessary to estimate the fixed amount of delay in advance. In a device such as a microprocessor or memory wherein the amount of clock delay can be estimated in advance, all design from design of transistors to design of wiring is performed collectively. This means that designing the clock driver dummy is not that difficult.

However, in a case where a synchronous delay circuit is used as a macro such as an ASIC (Application Specific Integrated Circuit), a transistor gate process for designing the dummy delay circuit and a wiring process which governs the actual clock delay represent separate design processes. With devices in which the amount of clock delay differs depending upon the wiring design used in the chip, designing the clock dummy delay circuit is difficult and it is necessary to design the dummy delay circuit after the wiring is laid out. This is highly inefficient.

Accordingly, the pattern designed in advance as a macro is solely that of the delay circuit chains 901, 902, and it is necessary to acquire an area for the clock driver dummy 905B beforehand (see Fig. 9) for purposes of layout. This is uneconomical.

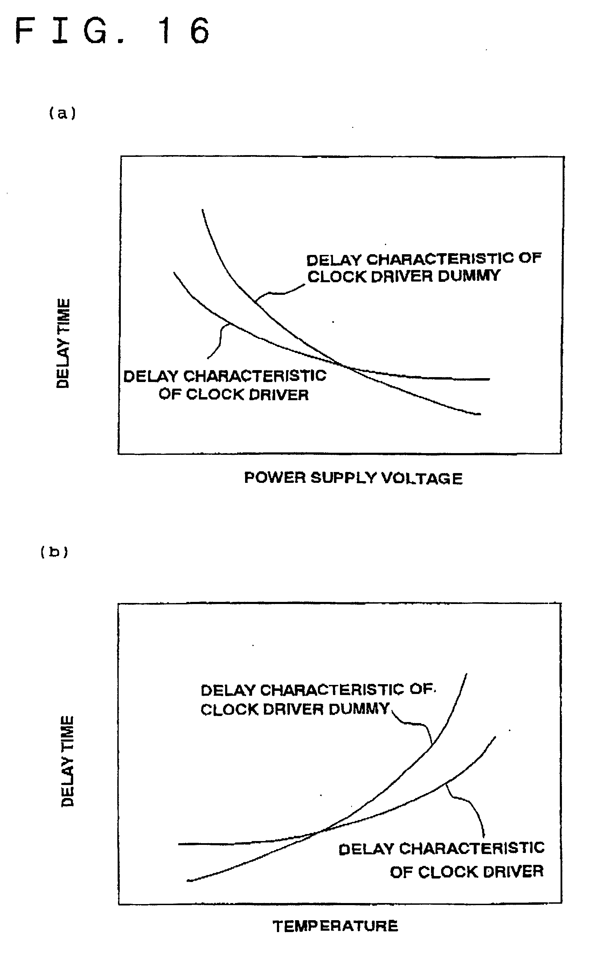

Also, in devices in which it is possible to pre-estimate the clock delay quantity in micro-processors or memory devices, the delay quantity of the clock driver dummy and that of the original clock driver produce difference in the temperature and source voltage dependency of the delay time, as shown in Fig.16, such that it is difficult to realize satisfactory matching of characteristics.

The result is that the error between the delay amount of the clock driver and that of the original clock driver occasionally leads to error in skew removal.

In the conventional synchronous delay circuit explained with reference to Figs.25 and 26, the time required for skew removal needed 3.5 clocks, due to addition of the double frequency and Duty50 functions. On the other hand, elongation of the synchronous time leads to only insufficient exploitation of the merits of the circuit.

Accordingly, an object of the present invention is to provide a synchronous delay circuit that dispenses with a clock driver dummy delay circuit, wherein even if the circuit is applied to a device such as an ASIC in which the amount of clock delay differs from chip to chip, it is no longer necessary to design a clock driver dummy whenever a wiring design is changed and no longer necessary to give consideration to the layout of an area for the clock driver dummy, thereby making possible highly efficient, economical design.

It is another object of the present invention to provide a synchronous delay circuit whereby the time required for obtaining the internal clocks of the double frequency substantially free of skew withe respect to external clocks, and internal clocks of Duty50.

These objects are achieved by a synchronous delay circuit as claimed in claim 1; the dependent claims are related to further developments of the invention.

According to the present invention, the foregoing object is attained by providing a synchronous delay circuit comprising a first delay circuit chain propagating a pulse or pulse edge therethrough for a fixed period of time, a second delay circuit chain capable of passing a pulse or pulse edge over a length proportional to the length of the first delay circuit chain along which the pulse or pulse edge propagated, and a circuit outputting a monitor signal for a period of time over which a clock pulse is propagating through a clock driver, wherein the first delay circuit chain is constituted by a clocked inverter and propagation of the pulse or pulse edge through the first delay circuit chain is halted at any desired timing during the output of the monitor signal.

During the time period when the clock pulses travel through the first delay circuit chain 1 and when the pulses or edges travel through the clock driver during the clock period tCK, the progress of the pulses or edges in the first delay circuit chain is halted in order to realize the delay of tCK - (d1+d2) without clock driver dummy.

The synchronous delay circuit according to another aspect of the present invention includes a first delay circuit chain for allowing pulses or pulse edges to proceed for a pre-set time, a second delay circuit chain allowing pulses or pulse edges to travel therethrough a length proportionate to the length by which the pulses or pulse edges travel through the first delay circuit chain, and a circuit for retrieving monitoring signals during the period the clock pulses are traveling through the clock driver, the first delay circuit chain being formed by a clocked inverter and travel of the pulses or edges through the first delay circuit chain being halted at any desired timing during outputting of the monitoring signals.

The synchronous delay circuit according to a third aspect of the present invention also includes a third delay circuit chain for allowing pulses or pulse edges to proceed for a pre-set time, and a second delay circuit chain allowing pulses or pulse edges to travel therethrough a length proportionate to the length by which the pulses or pulse edges travel through a fourth delay circuit chain, the third delay circuit chain being formed by a clocked inverter, with the clocks being halted during any desired period of time after allowing the pulses or pulse edges to travel through the fourth delay circuit chain for a pre-set period.

The present. invention is hereinafter explained with reference to preferred embodiments thereof.

Embodiment 1

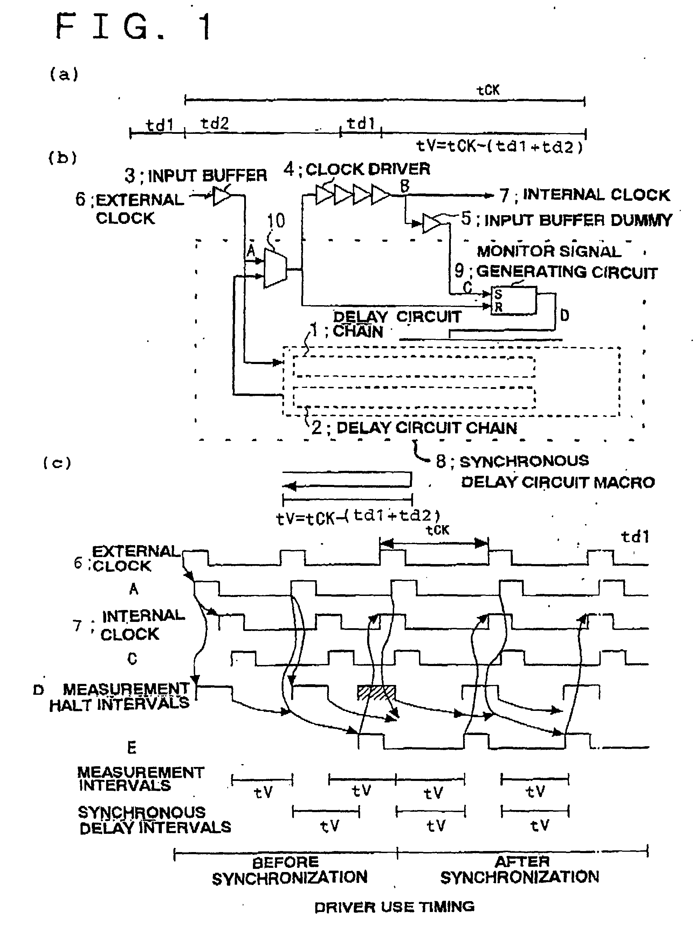

Fig.1 shows a constitution of a synchronous delay circuit according to a first embodiment of the present invention and a timing chart. Referring to Fig.1, the first embodiment of the present invention includes a synchronous delay circuit made up of a delay circuit chain 1 for measuring a pre-set time interval, a delay circuit chain 2 for reproducing the measured delay time, the input buffer 3 and the clock driver 4. The clock driver 4 furnishes internal clocks 7 to an internal circuit (sequencing circuit), not shown. An input dummy 5 is configured similarly to the input buffer 4 and has the same delay time.

An output A of the input buffer 3 is sent to an input end of a switch 10 (changeover unit) and to the delay circuit chain 1 for measuring the period. To the other input end of the switch 10 is entered an output of the delay circuit chain 2 for reproducing the delay. An output of the switch 10 is sent to an input of the clock driver 4 and to a reset terminal of a monitor signal generating circuit 9. An output of the clock driver 4 is supplied via the input dummy 5 to a set terminal of the monitor signal generating circuit 9, an output D of which is sent to the delay circuit chain 1. The monitor signal generating circuit 9 outputs the monitor signal D, by way of activation thereof, during the time clock pulses are traveling through the clock driver 4 and the input dummy 5.

In the first embodiment of the present invention, the clock period is measured by allowing the clock signals to pass through the delay circuit chain 1 used for measurement. However, during the time when clock skew is likely to be produced, as when the clocked pulses are traveling through the clock driver 4 or when the clocked pulses are traveling through the input dummy 5, the monitor signal D from the monitor signal generating circuit 9 becomes active to inhibit signal passage through the delay circuit chain 1 to discontinue the measurement of the clock period tCK.

Therefore, the time during which signals travel through the delay circuit chain 1 (during measurement time) is just equal to the clock period tCK less the sum of the delay time td2 of the input buffer 3 and the delay time td1 of the clock driver 4 ($tV = tCK - (td1+td2)$), while the delay time reproduced by the delay circuit chain 2 (synchronous delay time) is $tV = tCK - (td1+td2)$.

The result is that just one clock has to pass for the clock pulse to pass through the input buffer 3, delay circuit chain 2 and the clock driver 4 ($td2 + td1 + tV = td2 + td1+ tCK - (td1 + td2) = tCK$) such that the internal clocks 7 output by the clock driver 4 are substantially freed of skew with respect to the external skew.

Other features and advantages of the present invention will be apparent from the following description taken in conjunction with the accompanying drawings, in which like reference characters designate the same or similar parts throughout the figures thereof.

Fig. 1 is a diagram illustrating an arrangement for practicing the present invention, as well as an associated timing chart;

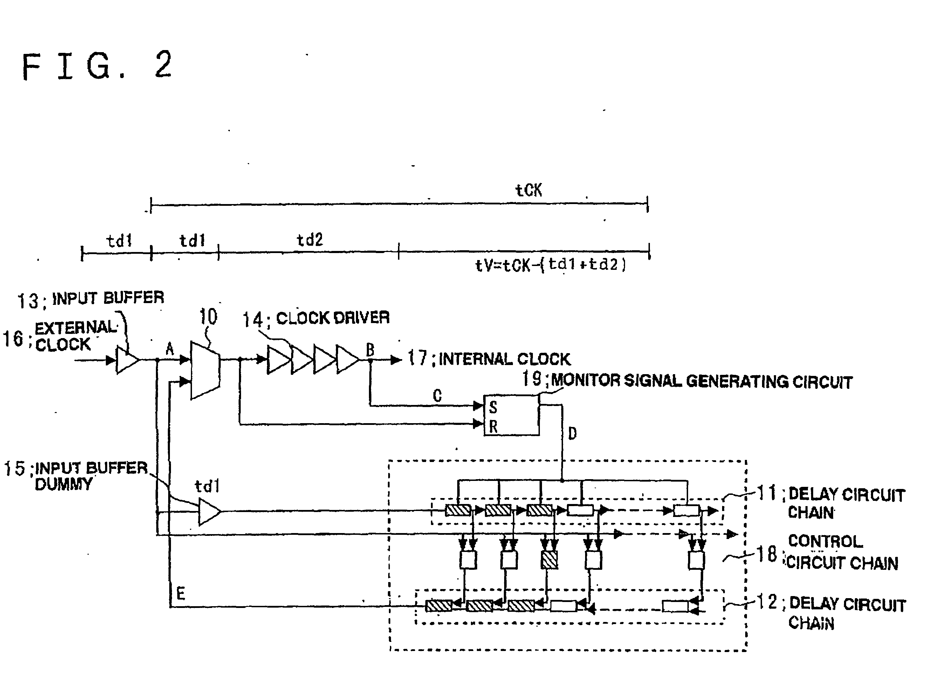

Fig. 2 is a diagram showing a circuit arrangement according to a first embodiment of the present invention;

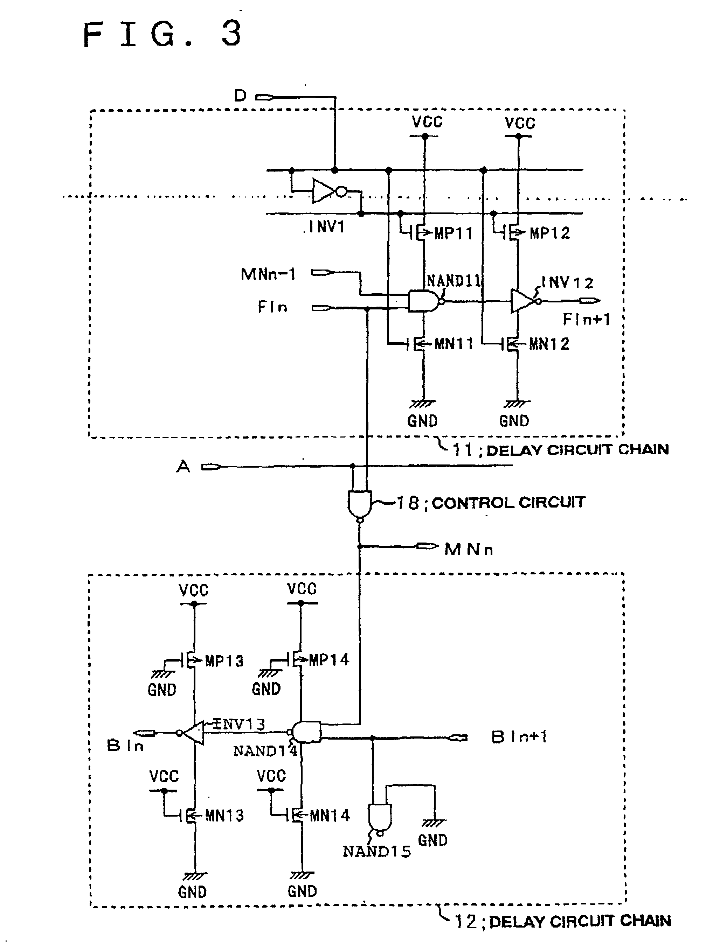

Fig. 3 is a diagram showing an example of elements constituting the first embodiment of the present invention;

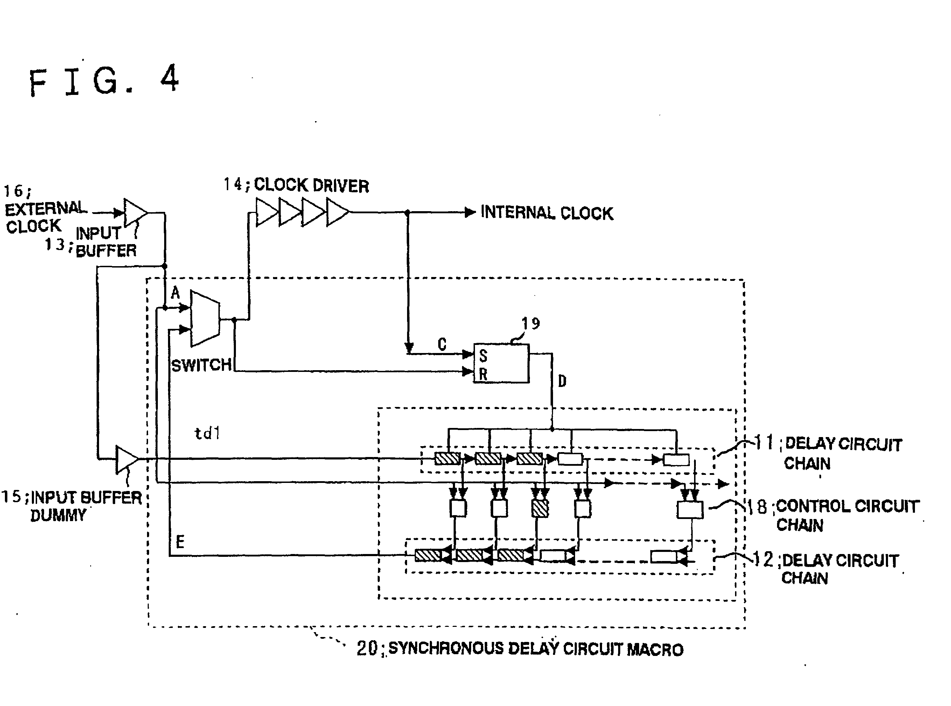

Fig. 4 is a diagram showing the construction of a macro according to the first embodiment of the present invention;

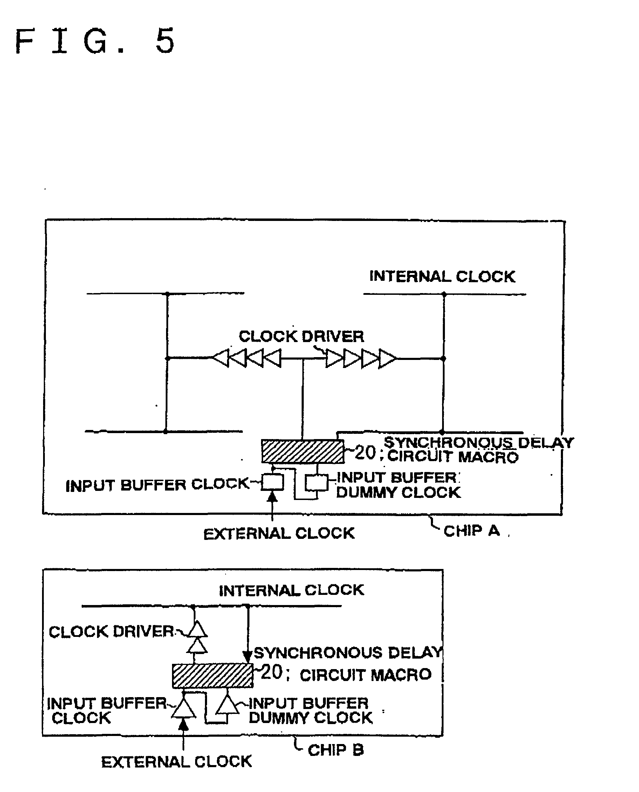

Fig. 5 is a diagram showing the layout of elements in the chip of a macro according to the first embodiment of the present invention;

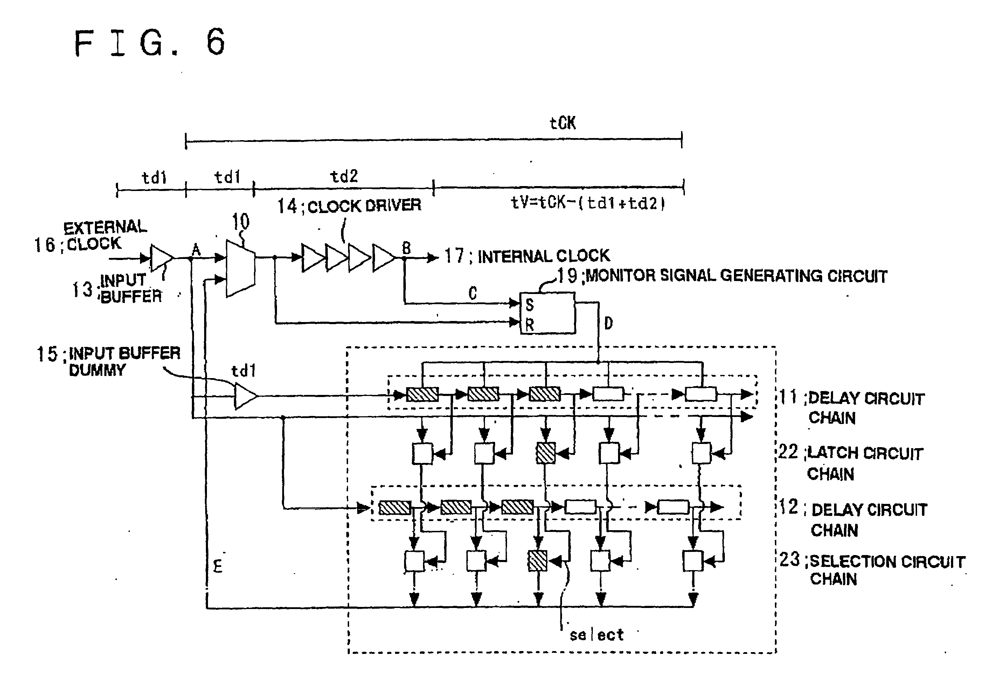

Fig. 6 is a diagram showing a circuit arrangement according to a second embodiment of the present invention;

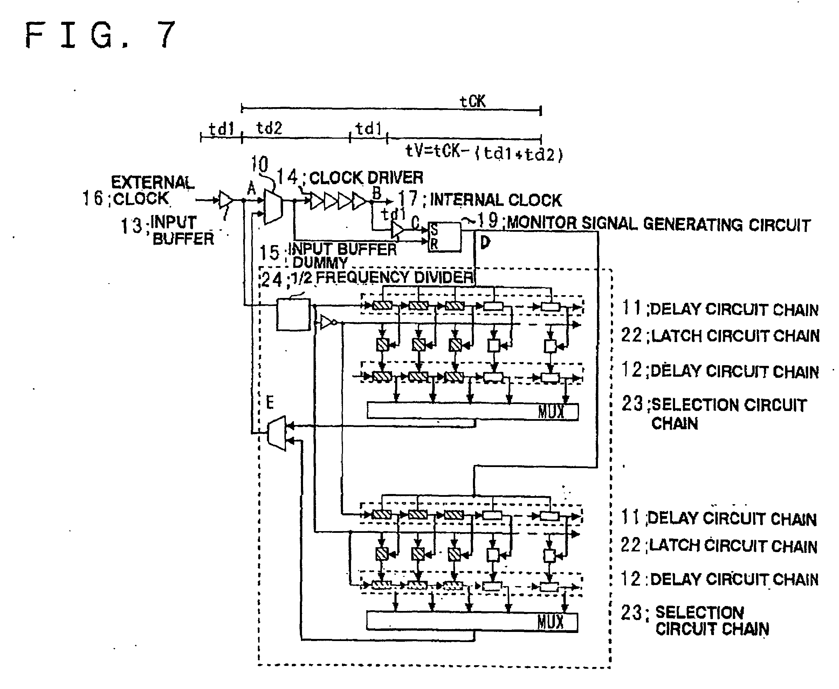

Fig. 7 is a diagram showing a circuit arrangement according to a third embodiment of the present invention;

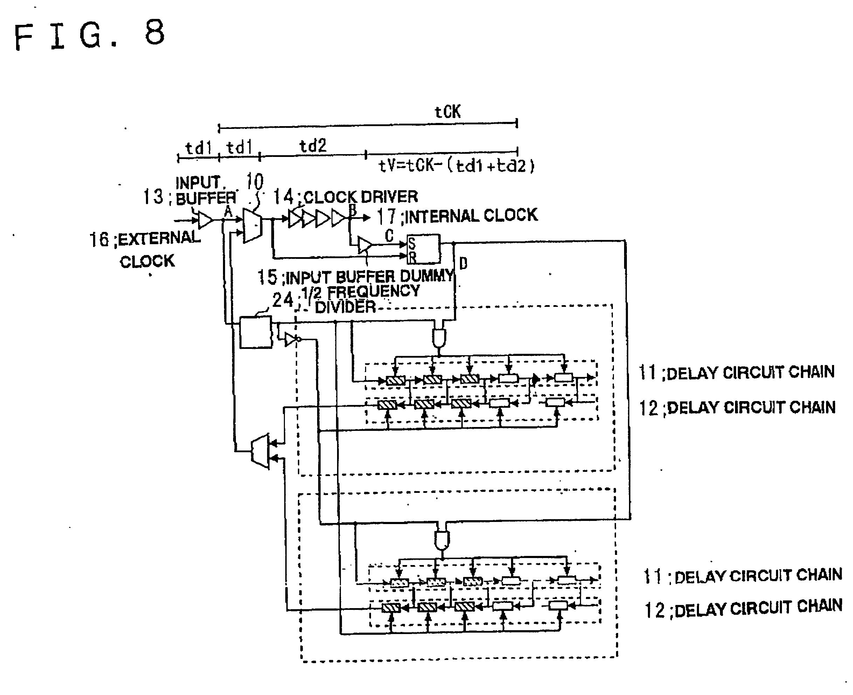

Fig. 8 is a diagram showing a circuit arrangement according to a fourth embodiment of the present invention;

Fig. 9 is a diagram showing a circuit arrangement according to the prior art;

Fig. 10 is a diagram showing a first circuit arrangement according to the prior art;

Fig. 11 is a diagram showing a second circuit arrangement according to the prior art;

Fig. 12 is a diagram showing a third circuit arrangement according to the prior art;

Fig. 13 is a diagram showing a fourth circuit arrangement according to the prior art;

Fig. 14 is a diagram illustrating a circuit arrangement that does not use a synchronous delay circuit, as well as an associated timing chart;

Fig. 15 is a diagram illustrating a circuit arrangement that uses a synchronous delay circuit according to the prior art, as well as an associated timing chart; and

Figs. 16A and 16B are characteristic diagrams showing the dependence of clock driver and dummy circuit delay times on power supply voltage and temperature.

Fig.16 is a graph showing delay characteristics of a dummy delay circuit and a clock driver.

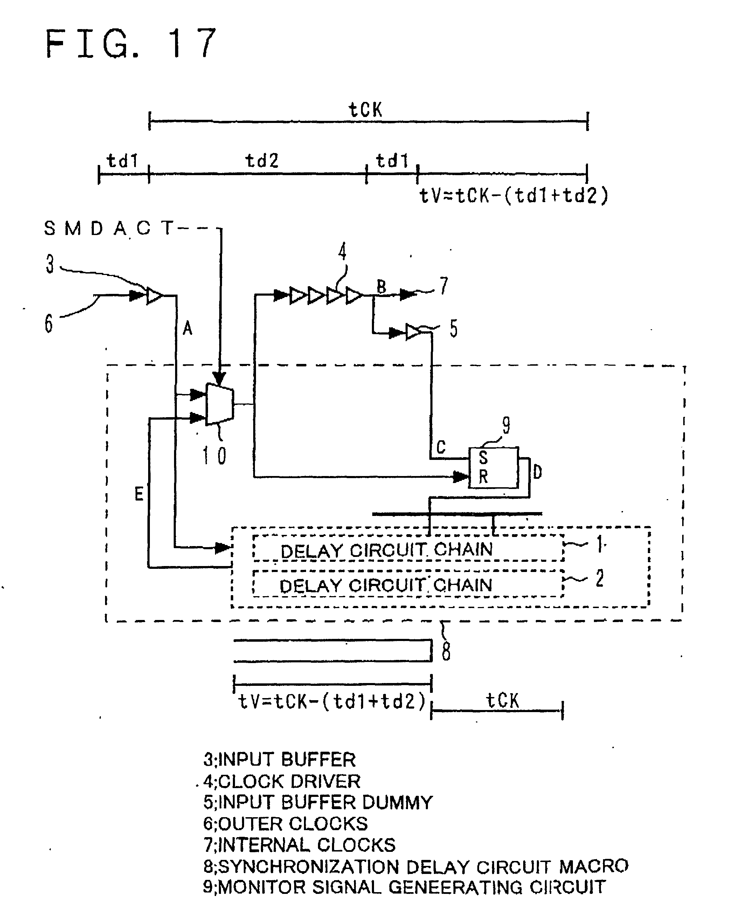

Fig.17 shows the configuration of a second embodiment of the present invention.

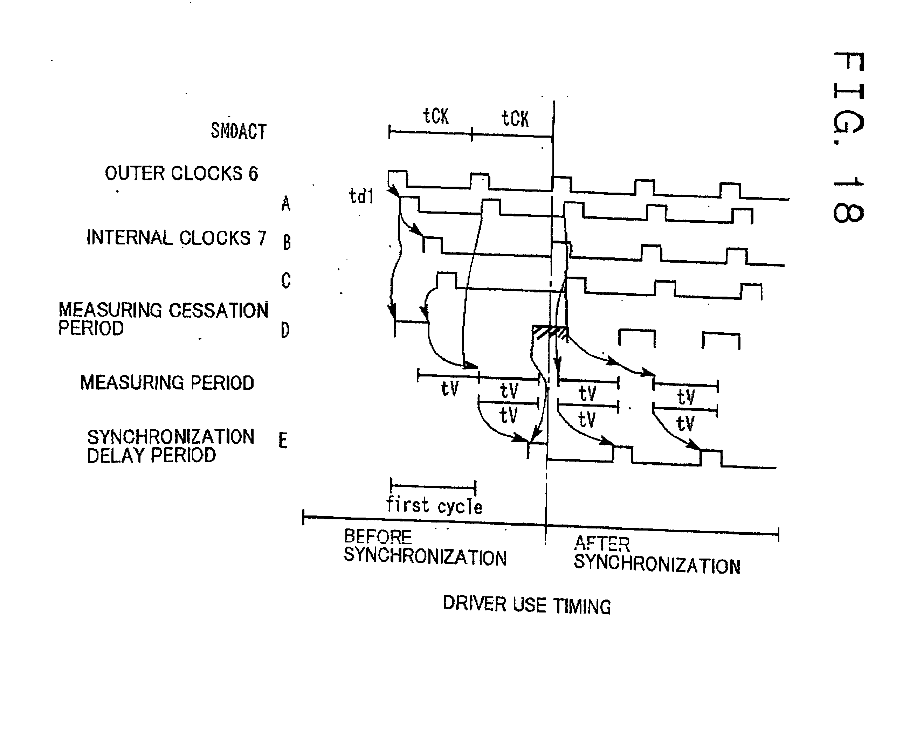

Fig.18 is a timing chart for illustrating the operation of the second embodiment of the present invention.

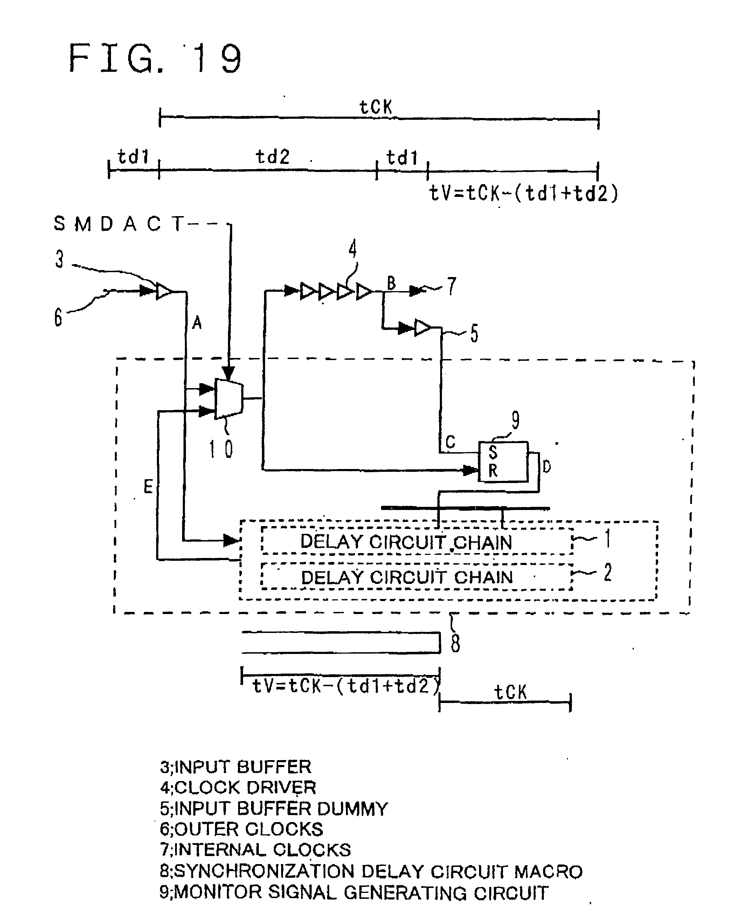

Fig.19 shows a circuit structure of a fifth example of the present invention.

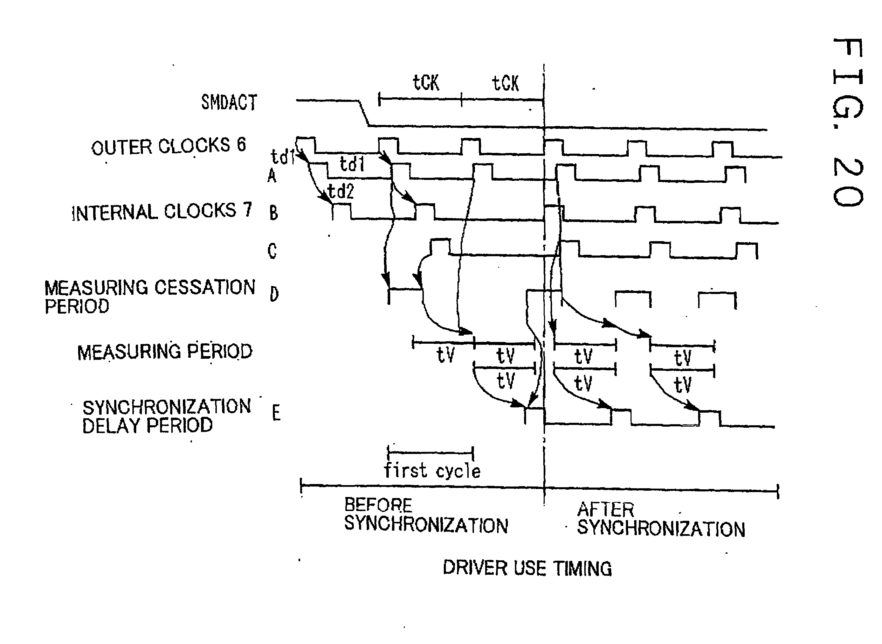

Fig.20 is a timing chart for illustrating the operation of the fifth example.

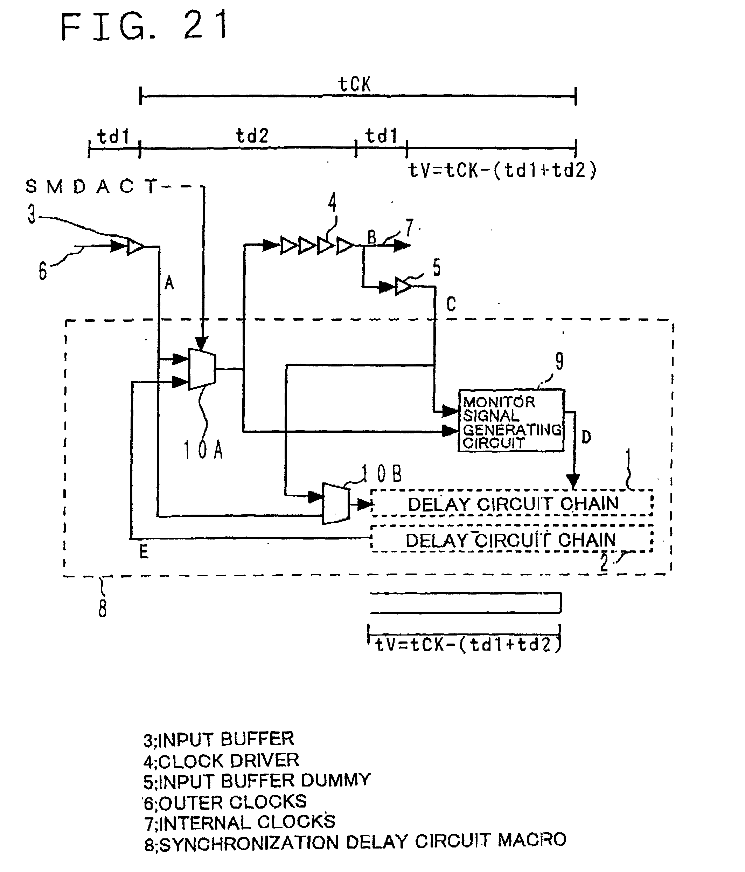

Fig.21 shows a structure of a third embodiment (sixth example) of the present invention.

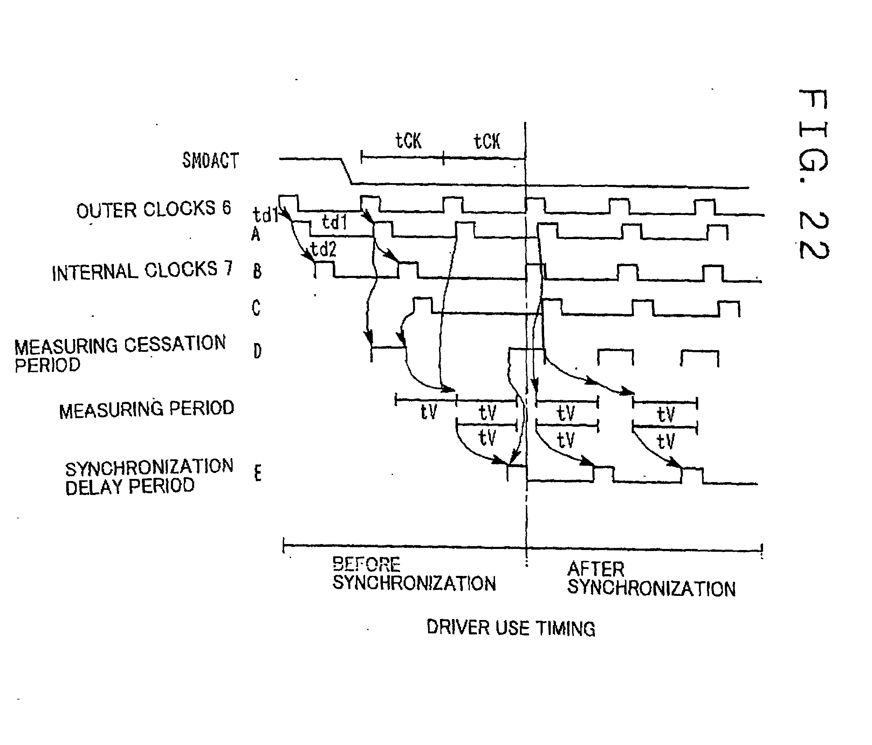

Fig.22 is a timing chart for illustrating the operation of the third embodiment of the present invention.

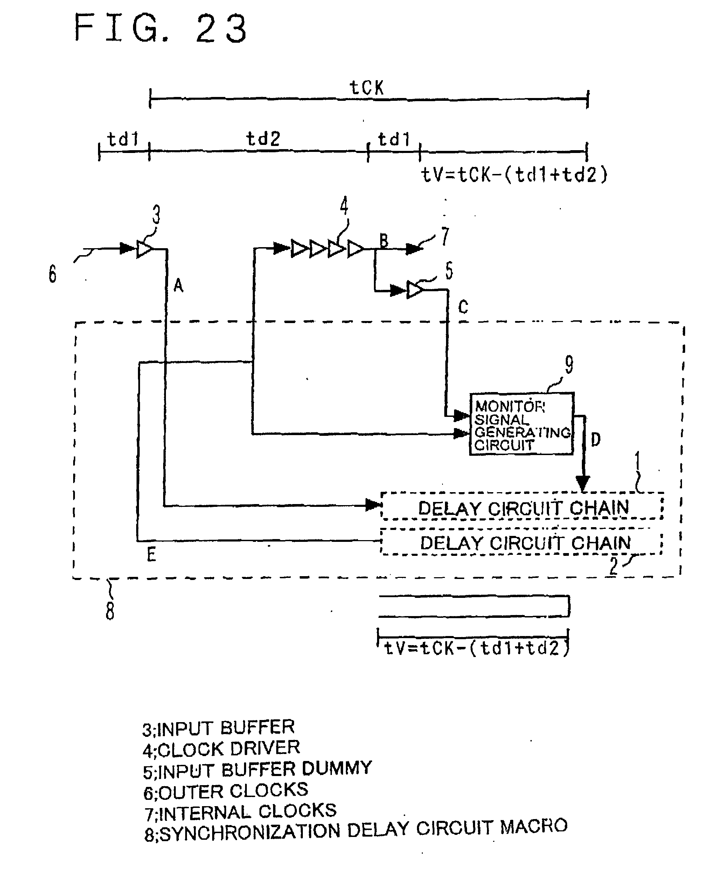

Fig.23 shows a structure of a fourth embodiment (seventh example) of the present invention.

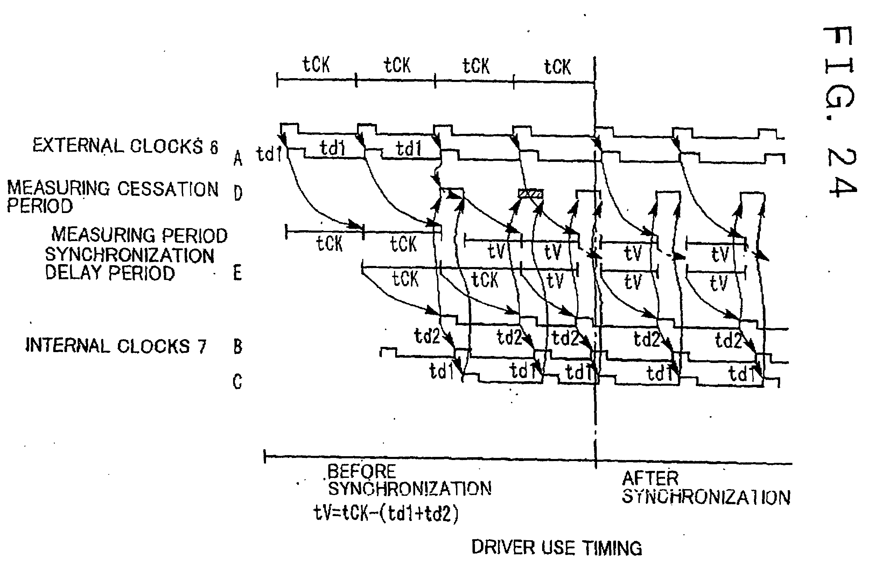

Fig.24 is a timing chart for illustrating the operation of the fourth embodiment.

Fig.25 shows a structure of a synchronous delay circuit for generating internal clocks of the double frequency and Duty50.

Fig.26 is a timing chart for illustrating the operation of the synchronous delay circuit shown in Fig.25.

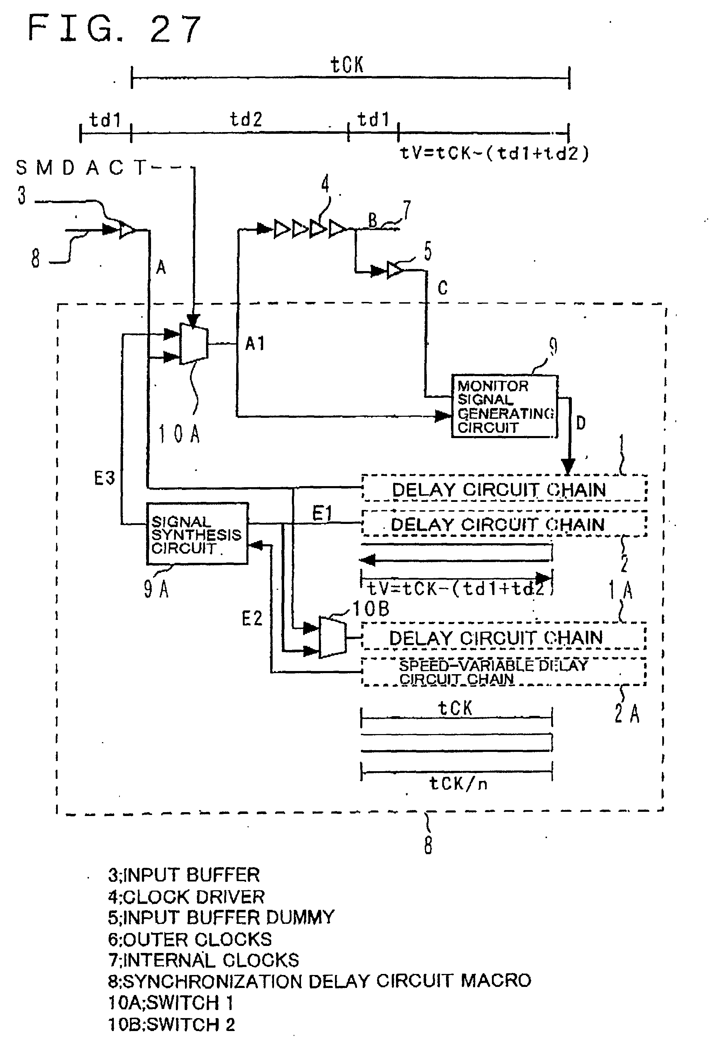

Fig.27 shows the structure of the fourth embodiment (eighth example) of the present invention.

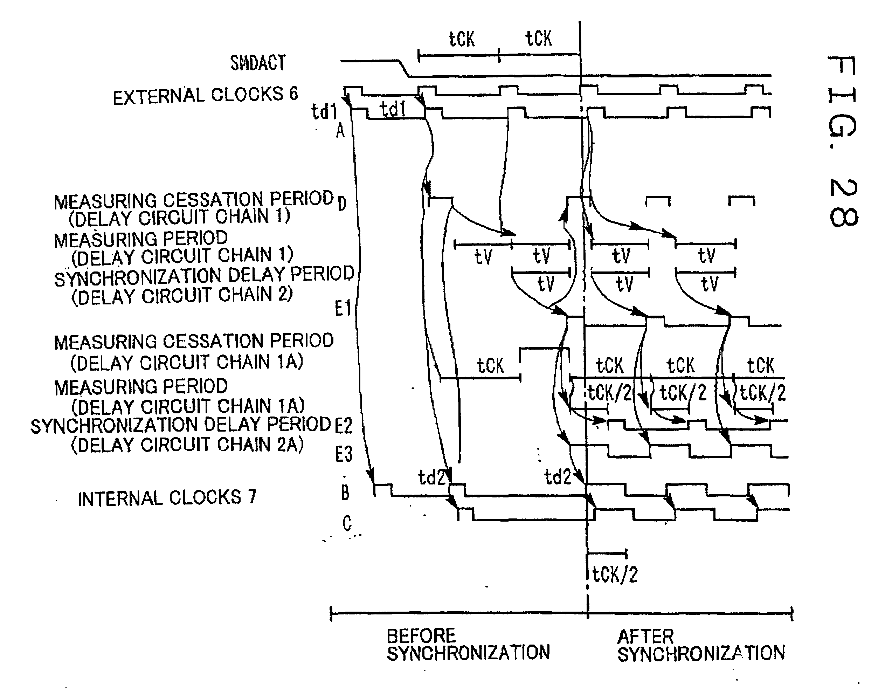

Fig.28 is a timing chart for illustrating the fourth embodiment of the present invention.

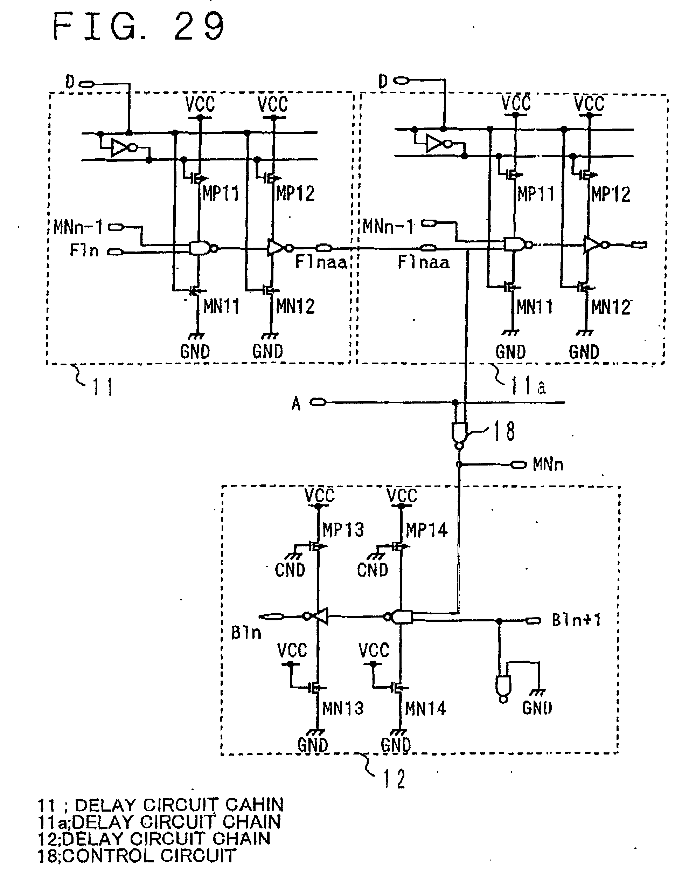

Fig.29 shows an example of the structure of a delay circuit chain in the fourth embodiment of the present invention.

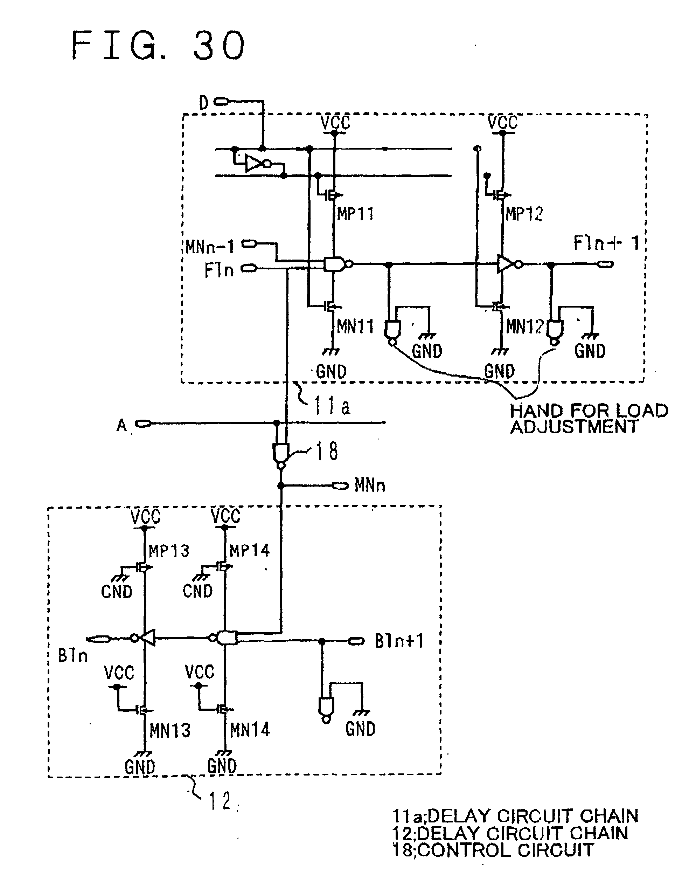

Fig.30 shows a typical structure of a delay circuit chain in the fourth embodiment of the present invention.

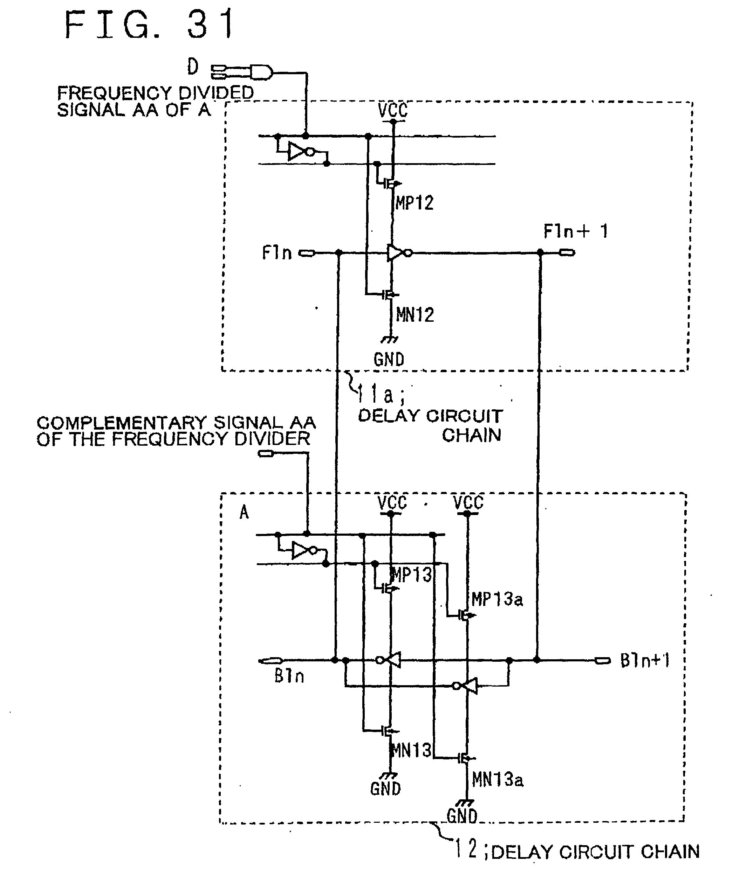

Fig.31 shows another typical structure of the delay circuit chain in the fourth embodiment of the present invention.

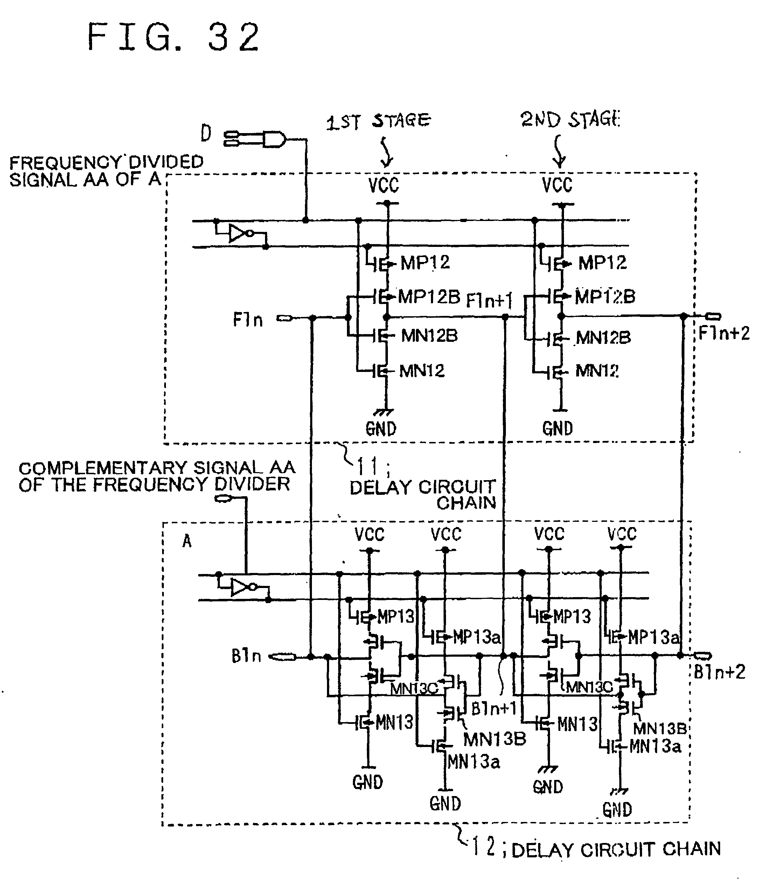

Fig.32 shows still another typical structure of the delay circuit chain in the fourth embodiment of the present invention.

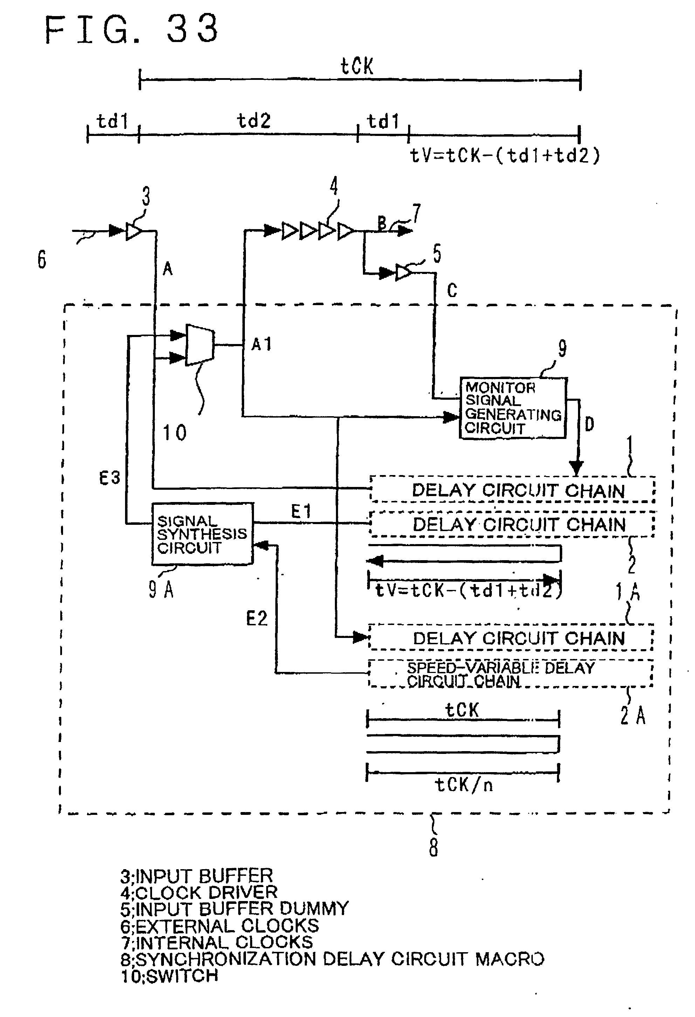

Fig.33 shows yet another typical structure of the delay circuit chain in the fourth embodiment of the present invention.

Further, a monitor signal generating circuit 9 for outputting a monitor signal D in the period of time during which a pulse is propagating through the clock driver 4 and input buffer dummy 5 is constituted by an RS flip-flop or the like. In a case where the time (td1 + td2), which is obtained by adding the amounts of delay in the clock driver 4 and input buffer dummy 5, is longer than the clock period tCK, the monitor signal generating circuit 9 outputs the monitor signal D for a period of time equivalent to this excess time, namely for a period of time equivalent to the remainder obtained by dividing the sum of the delays of clock driver 4 and input buffer dummy 5 by the clock period tCK. The monitor signal D halts the signal undergoing measurement in the delay circuit chain 1. Consequently, clock skew is eliminated even in a case where the sum of the delays of clock driver 4 and input buffer dummy 5 is longer than the clock period tCK.

As shown in the timing chart of Fig. 1(c), the monitor signal D that halts the propagation of the clock signal through the delay circuit chain 1 monitors the period of time over which the clock pulse traverses the clock driver 4. This means that the timing at which the clock pulse propagates through the clock driver 4 becomes earlier by tCK - (td1 + td2) from the moment the clock has been synchronized. Accordingly, at the changeover from the state before synchronization to the state after synchronization, the monitor signal D will output two times in one period. (This is indicated by the shaded signal portion of the monitor signal D and the signal portion preceding it in the timing chart of Fig. 1 (c).) However, this is avoided by halting the shaded monitor signal D in the timing chart of Fig. 1(c) by the first output of a signal E, which is the output of the delay circuit chain 2, or by halting the shaded monitor signal D in the timing chart of Fig. 1(c) by a method such as halting the advance of a pulse to the clock driver 4.

Preferred embodiments of the present invention will now be described in greater detail with reference to the drawings starting with examples for the embodiments.

[First Example]

Fig. 2 is a diagram showing a circuit arrangement according to a first example of the present invention.

This example employs a scheme in which a delay circuit chain 11 for measuring the clock period tCK and a delay circuit chain 12 for reconstructing the measured period are arranged in mutually opposing directions.

This scheme in which the delay circuit chain 11 and the delay circuit chain 12 for reconstructing the measured period are arranged in opposite directions is such that a clock pulse propagates through the delay circuit chain 11 and then is transferred to the delay circuit chain 12 via a control circuit chain 18 when the next clock pulse is output by an input buffer 13. This arrangement corresponds to the scheme set forth in Japanese Patent Application Laid-Open No. 8-137091 described above in connection with Fig. 10.

More specifically, the arrangement shown in Fig. 2 comprises the delay circuit chain 11 capable of extracting an output from any position along the signal transfer path, the delay circuit chain 12 capable of accepting a signal from any position along the signal transfer path, and a control circuit chain 18 having signal input terminals, signal output terminals and input/output control terminals. The delay circuit chains 11 and 12 are so arranged that their signal transfer paths are in opposing directions. Sides near the input to the delay circuit chain 11 and sides near the output of the delay circuit chain 12 are successively connected via the control circuit chain 18. After a signal enters the delay circuit chain 11, a signal enters an input/output control terminal of the control circuit chain 18 and a signal in the delay circuit chain 11 is transferred to the delay circuit chain 12.

Fig. 3 is a diagram showing the construction of the delay circuit chain 11, delay circuit chain 12 and control circuit 18 according to this embodiment.

In order to dispense with a clock driver dummy, this example of the present invention is so adapted that the elements constituting the delay circuit 11 and delay circuit 12 construct clocked inverters. In the period of time over which a clock pulse passes through a clock driver 14, N-channel MOS transistors MN11, MN12 and P-channel MOS transistors MP11, MP12 are turned off by a signal D generated by a monitor signal generating circuit (SR flip-flop) 19 from the input and output of the clock driver 14, whereby the clock pulse is not allowed to propagate through the delay circuit chain 11. In other words, when a clock pulse enters the clock driver 14 in Fig. 2, the RS flip-flop 19 is reset so that the signal D assumes the low level. At the moment the clock pulse is output by the clock driver 14, the RS flip-flop 19 is set, as a result of which the signal D rises to the high level. Thus, in the period of time required for the clock pulse to traverse the clock driver 14, the signal D is at the low level and the MOS transistors are OFF.

The clocked inverter of the delay circuit 12 is arranged to provide a delay time equal to that of the delay circuit 11 and is ON at all times. That is, the design is such that MOS transistors MN13, MN14, MP13, MP14 are in the ON state.

An nth delay element will be described with reference to Fig. 3. An output FIn of an (n-1)th inverter (not shown) of the delay circuit chain 11 enters a NAND gate 11 and is connected to whichever input terminal of two input terminals of a NAND gate of the control circuit chain 18 is not connected to a control terminal A. An output MNn of the NAND gate of control circuit 18 is connected to whichever input terminal of two input terminals of an (n+1)th NAND gate (not shown) of the delay circuit chain 11 is not connected to the output FIn+1 of an nth inverter INV12, and is further connected to whichever input terminal of two input terminals of a NAND gate 14 in the delay circuit chain 12 is not connected to an output BIn+1 of the preceding inverter. The output of the NAND gate 14 of delay circuit chain 12 is connected to the input of an inverter INV13 of the delay circuit chain 12. The output BIn+1 of the preceding inverter of NAND gate 14 of delay circuit chain 12 enters the NAND gate 14 and is connected to whichever input terminal of two input terminals of a NAND gate 15 (a load adjusting element) is not connected to a ground line. The output of the NAND gate 15 constituting the ground adjusting element is left unconnected (i.e., the output is left in the open state).

As shown in Fig. 2, the input buffer dummy 15 is placed in front of the delay circuit chain 11, in a manner similar to that of the prior art. The time for passage of a signal is equal to that of the input buffer 3.

By virtue of this arrangement, the time required for a clock pulse to travel through the delay circuit chain 11 can be made tCK - (td1 + td2) in the manner described above.

Next, a circuit arrangement for a case where the macro of an ASIC (Application Specific Integrated Circuit) is constructed as a modification of the present invention will be described with reference to Fig. 4.

Circuits and wiring such as for the clock driver 14 and input buffer 13 which differ depending upon the ASIC chip cannot be laid out in a macro.

Accordingly, as shown in Fig. 4, the clock driver 14, input buffer 13 and input buffer dummy 15 are disposed externally of a synchronous delay circuit macro 20.

By thus placing elements that are dependent upon the chip construction externally of the macro, it is possible to eliminate clock skew, without performing any adjustment of clock driver dummy delay required in the prior art, even in a case where the synchronous delay circuit macro 20 is placed on chips A and B of different sizes and wiring, as shown in Fig. 5.

[Second Example]

Fig. 6 is a diagram illustrating a circuit arrangement according to a second example of the present invention.

As shown in Fig. 6, this example employs a scheme in which the delay circuit chain 11 for measuring the clock period tCK and the delay circuit chain 12 for reconstructing the measured period are arranged in the same direction.

This scheme in which the delay circuit chain 11 and the delay circuit chain 12 for reconstructing the measured period are arranged in the same direction is such that a clock pulse propagates through the delay circuit chain 11 and the output of the delay circuit chain 12 is selected when the next clock pulse is output by the input buffer 13. This arrangement corresponds to the scheme set forth in literature (2) (1996 Symp. on VLSI Circ. pp. 192 ~ 193), explained above in connection with Fig. 12.

In this example also the elements constituting the delay circuit 11 and delay circuit 12 construct clocked inverters. In the period of time over which a clock pulse passes through the clock driver 14, the clock pulse is not allowed to propagate through the delay circuit chain 11 by the signal D produced by the monitor signal generating circuit (RS flip-flop) 19 from the input and output of the clock driver 14. This makes it possible to eliminate the clock driver dummy. In addition, the circuitry can be used as an ASIC macro in a manner similar to that of the first embodiment.

[Third Example]

Fig. 7 is a diagram illustrating a circuit arrangement according to a third example of the present invention.

As shown in Fig. 7, this example employs a scheme in which the delay circuit chain 11 for measuring the clock period tCK and the delay circuit chain 12 for reconstructing the measured period are arranged in the same direction and a pulse edge is propagated through the circuit.

This scheme in which the delay circuit chain 11 and the delay circuit chain 12 for reconstructing the measured period are arranged in the same direction is such that a clock pulse edge propagates through the delay circuit chain 11 and the output of the delay circuit chain 12 is selected when the next clock pulse is output by the input buffer 13. This arrangement corresponds to the prior-art schemes set forth in literature (3) (Proc. of IEEE 1992 CICC 25.2) and in literature (2) (1996 Symp. on VLSI Circ., pp. 112 ~ 113) described above in connection with Fig. 13.

Since a clock pulse edge is used in this embodiment, measurement of the clock period by the delay circuit 11 and measurement by the delay circuit 12 is not possible by the single delay circuit 11 and the single delay circuit 12. Accordingly, a clock having a duty of 50% must be prepared and use of the measurement and delay circuits must be repeated every half period, or it is necessary to provide two sets of the delay circuit chains and operate the sets alternately every period.

In this example, two sets of the delay circuit chains are provided and the sets are operated alternately every period. In other words, the output of the input buffer 13 to which the external clock is applied is input to a 1/2 frequency divider 24, whereby the clock is frequency divided and then supplied to the two sets of delay circuit chains.

In this example also the elements constituting the delay circuit 11 and delay circuit 12 construct clocked inverters. In the period of time over which a clock pulse passes through the clock driver 14, the clock pulse is not allowed to propagate through the delay circuit chain 11 by the signal D produced by the monitor signal generating circuit 19 from the input and output of the clock driver 14. This makes it possible to eliminate the clock driver dummy. In addition, the circuitry can be used as an ASIC macro in a manner similar to that of the first embodiment.

[Fourth Example]

Fig. 8 is a diagram illustrating a circuit arrangement according to a fourth example of the present invention.

As shown in Fig. 8, this example employs a scheme in which the delay circuit chain 11 for measuring the clock period tCK and the delay circuit chain 12 for reconstructing the measured period are arranged in opposite directions and a pulse edge is propagated through the circuit.

This scheme in which the delay circuit chain 11 and the delay circuit chain 12 for reconstructing the measured period are arranged in opposite directions is such that a clock pulse edge travels through the delay circuit chain 11 and the output of the delay circuit chain 12 is selected when the next clock pulse is output by the input buffer 13. This arrangement corresponds to the prior-art scheme set forth in literature (4) (IEICE TRANS. ELECTRON., VOL. E79-C, No. 6, June, 1996, pp. 798 ~ 807) described above in connection with Fig. 11.

Since a clock pulse edge is used in this example, measurement of the clock period by the delay circuit 11 and measurement by the delay circuit 12 is not possible by the single delay circuit 11 and the single delay circuit 12. Accordingly, two sets of the delay circuit chains are provided and the sets are operated alternately every period.

In this example also the elements constituting the delay circuit 11 and delay circuit 12 construct clocked inverters. In the period of time over which a clock pulse passes through the clock driver 14, the clock pulse is not allowed to propagate through the delay circuit chain 11 by the signal D produced by the monitor signal generating circuit 19 from the input and output of the clock driver 14. This makes it possible to eliminate the clock driver dummy. In addition, the circuitry can be used as an ASIC macro in a manner similar to that of the first embodiment.

Embodiment 2

The second embodiment of the present invention is now explained. Fig.17 shows the configuration of the second embodiment of the present invention and Fig.18 shows the timing chart for illustrating the operation of the second embodiment and specifically illustrate the timing waveform of various components of Fig.1, respectively

Referring to Fig.17, the second embodiment of the present invention includes a synchronous delay circuit made up of a delay circuit chain 1 for measuring a pre-set time interval and a delay circuit chain 2 for reproducing the measured delay time. The second embodiment also includes an input buffer 3, a clock driver 4, an input dummy 5 and a monitor signal generating circuit 9. The clock period is measured by allowing the clock signals to pass through the delay circuit chain 1 used for measurement. However, during the time clock skew is likely to be produced, as when the clocked pulses are traveling through the clock driver 4 or when the clocked pulses are traveling through the input dummy 5, the clock signals are prohibited from proceeding through the delay circuit chain 1 to discontinue the measurement of the clock period tCK.

Therefore, the time during which signals are traveling through the delay circuit chain 1 is just equal to the clock period tCK less the sum of the delay time td2 of the input buffer 3 and the delay time td1 of the clock driver 4 ( tCK - (td1+td2), while the delay time reproduced by the delay circuit chain 2 is also tCK - (td1+td2).

The result is that just one clock has to pass for the clock pulse to pass through the input buffer 3, delay circuit chain 2 and the clock driver 4 such that the internal clocks 7 output by the clock driver 4 are substantially freed of skew. Meanwhile, the switch 10 switches between the output of the delay circuit chain 12 and the external clocks 6 by a signal SMDACT.

If, when the circuit for outputting the monitor signal during the time the pulses are traveling through the clock driver 4 and the input dummy 5 by a set-reset flipflop (SR flipflop), the sum of the delay in the clock driver 4 and that in the input dummy 5 (td1+td2) is longer than the clock period tCK, the monitor D is output during the time corresponding to the time exceeding the clock period tCK, that is the residual of the time corresponding to the quotient of the sum of the delay time of the clock driver 4 and that of the input dummy 5 divided by the clock period tCK to halt the signal in the delay circuit chain 1 used for measurement. That is, clock skew may be removed even if the sum of the delay time td1 of the clock driver 4 and the delay time td2 of the input dummy 5 is longer than the clock period tCK.

In the timing chart shown in Fig.18, the monitor signal D which halts the progress of the clock signals monitors the time period during which the clock pulses are traveling through the clock driver 4. The timing of passage through the clock driver 4 is quickened by tCK - (td1+td2) as from the time of clock synchronization.

Therefore, when switching from pre-synchronization to post-synchronization, the monitor signal D is output twice during one clock period. In the timing chart of Fig.18, a monitor signal D shown by hatching and a subsequent signal thereof are outputted. This can be evaded by methods such as

(i) by halting the monitor signal at the timing shown hatched in Fig.18; or
(ii) by switching the clock path for halting the progress of pulses to the clock driver 4,

after first outputting the internal clock 7 or after outputting the first monitor signal D.

That is, with the second embodiment of the present invention, a monitor signal D directly preceding the monitor signal D to be halted, shown by hatching at D in Fig.1(C) in the first embodiment shown in Fig.1, is halted.

In the second embodiment, the internal clock not freed of skew is output only once, such that the clock skew can be removed at a faster timing than with the above-described first embodiment.

The second embodiment of the present invention is explained in detail hereinbelow.

Example 5

Fig.19 shows the constitution of the fifth example of the present invention. Fig.20 shows a timing chart for illustrating the operation of the fifth example. Referring to Fig.19, showing the fifth example, the specific circuit structure of the delay circuits 1 and 2 are similar to that of each of the first to fourth examples.

In the preset example, switching of the clock paths is performed by an external signal SMDACT entering the switching circuit 10 as a switching control signal. In Fig.20, after SMDACT is set to the low level and the operating mode is initiated, the external clock signal 6 is allowed to pass through a path from the input buffer 3 through the switch 10 to the clock driver 4. An output of the clock driver 4 is once supplied as an internal clock 7, after which the pulse path from the input buffer 3 to the clock driver 4 is switched to the pulse path to the delay circuit chain 1. This generates the monitor signal D without waste.

Although the delay circuit chains 1, 2 are shown linearly, these may be arranged in a ring, as shown in JP Patent Kokai JP-A-8-237091, to cause rotation of the clock signals to permit the number of revolutions by a counter. This can be applied to all of the different forms of the delay circuits used in the first to fourth examples.

Embodiment 3

Fig.21 shows the structure of a third embodiment of the present invention and Fig.22 shows a timing chart for illustrating the operation of the third embodiment of the present invention. Referring to Fig.21, the present third embodiment includes a synchronous delay circuit made up of a delay circuit chain 1 for estimating a pre-set time interval and a delay circuit chain 2 for reproducing the estimated delay time. The present third embodiment also includes an input buffer 3, a clock driver 4, an input buffer dummy 5, a monitor signal generating circuit 9 and first and second switches (changeover units) 10A, 10B.

The first switch 10A switches between an output of the input buffer 3 and an output of the delay circuit chain 2 used for delay reproduction by the control signal SMDACT to send the selected signal to the clock driver 4 and to the monitor signal generating circuit 9. The second switch 10B is fed with an output of the input buffer 3 and an output of the input buffer dummy 5 to send one of the outputs to an input of the delay circuit chain 1 used for clock period measurement.

The clock period is measured by allowing the clock signals to pass through the delay circuit chain 1 used for measuring the clock period. However, during the time clock skew is likely to be produced, as when the clocked pulses are traveling through the clock driver 4 or when the clocked pulses are traveling through the input buffer dummy 5, passage of clock signals through the delay circuit chain 1 is inhibited to discontinue the measurement of the clock period tCK.

Therefore, the time during which signals are traveling through the delay circuit chain 1 is just equal to the clock period tCK less the sum of the delay time td2 of the input buffer 3 and the delay time td1 of the clock driver tCK - (td1+td2), while the delay time reproduced by the delay circuit chain 2 (synchronous delay time) assumes also tCK - (td1+td2).

The result is that just one clock period tCK is required for the clock pulse to pass through the input buffer 3, delay circuit chain 2 and the clock driver 4 such that the internal clocks 7 are substantially freed of skew with respect to the external clocks.

Also, if, when the circuit for outputting the monitor signal during the time the pulses are traveling through the input buffer 3 and the input buffer dummy 5 by a SR flipflop, the sum of the delay in the clock driver 4 and that in the input buffer dummy 5, (td1+td2), is longer than the clock period tCK, the monitor signal D is output during the time corresponding to the time exceeding the clock period tCK, that is the residual of the time corresponding to the quotient of the sum of the delay time of the clock driver 4 and that of the input driver 3 by the clock period to halt the progress of the signal in the delay circuit chain 1 used for measurement. That is, clock skew may be removed even if the sum of the delay time td1 of the clock driver 4 and the delay time td2 of the input dummy 5 is longer than the clock period tCK.

In the timing chart shown in Fig.18, the monitor signal D which halts the progress of the clock signals monitors the time period during which the clock pulses are traveling through the clock driver 4. The timing of passage through the clock driver 4 is quickened by tCK - (td1+td2) as from the time of clock synchronization.

In a third embodiment of the present invention, the clock signals pass through the input buffer 3, first switch 10A, clock driver 4 and the input dummy 5 before synchronization and are subsequently input to the measurement delay circuit chain 1 through the second switch 10B in order to measure the time of tCK-(td1+td2). Also, the monitor signal D is output at the time of synchronization in order to measure the time of tCK - (td1+td2).

Thus, there is no possibility of the monitor signal D being output twice during one clock period as a result of the switching from the pre-synchronization state to the post-synchronization state as compared to the case of the first and second embodement.

In the third embodiment of the present invention, measurement of the clock period is halted at a signal just ahead of the monitor signal D shown by hatching in Fig.1c. Thus, with the third embodiment of the present invention, only one internal clock signal not freed of skew is issued so that the clock skew is removed at a timing one period faster than in the first embodiment.

Referring to the drawings, the third embodiment of the present invention will be explained in detail.

Example 6

Fig.21 shows a configuration of the third embodiment of the present invention and Fig.22 is a timing chart for illustrating the operation thereof.

In the present example, the specified structure of the delay circuit chains 1 and 2 are similar to that of the first to fourth examples described above.

In the present example, the clock path is switched by the external signal SMDACT (by SMDACT going low in Fig.22) to enter the operating mode and subsequently the external clock signal 6 is once furnished as the internal clock signal 7. The clock signals are then passed from the input buffer 3 to the clock driver 4. The time of tCK - (td1+td2) is measured by the clock pulses passing through the input buffer dummy 5 to enter the delay circuit chain 1 used for measurement. From the next clock signals on, the clock signal path is changed to a path from the input buffer 3 and the second switch 10B which has selected an output of the input buffer 3 through the delay circuit chain 1 for measurement and the delay circuit chain 2 for delay reproduction to the first switch 10A which has selected the output of the input buffer 3 and to the clock driver 4 in order to remove the skew of the external clock 6 and the internal clock 7, that is in order to synchronize the two clocks.

From this time on, the monitor signal D is output to measure the time of tCK - (td1+td2).

Thus, there is no risk of the monitor signal D being output twice by switching from the pre-synchronized state to the postsynchronized state.

Although the delay circuit chains 1 and 2 described above are of a linear configuration, these may also be arranged in a ring shape as already shown in JP Patent Kokai JP-A-8-237091, with the clock signals being rotated and the number of revolutions thereof being counted by a counter. This configuration may be applied to all sorts of the delay circuits used in the first to fourth embodiments.

Embodiment 4

Fig.23 shows the configuration of the fourth embodiment of the present invention and Fig.24 is a timing chart for illustrating the operation of the fourth embodiment.

Referring to Fig.23, the fourth embodiment of the present invention includes a synchronous delay circuit made up of a delay circuit chain 1 for measuring a pre-set time and a delay circuit chain 2 for reproducing the measured delay time. The fourth embodiment also includes an input buffer 3, a clock driver 4, an input buffer dummy 5 and a monitor signal generating circuit 9. The clock period is measured by passing the clock signals through the delay circuit chain 1 used for measurement. During the period responsible for clock skew, such as the period during which the clock pulses are travailing through the clock driver 4 or the period during which the clock pulses are traveling through the input buffer dummy 5, the clock signals are prohibited from being passed through the delay circuit chain 1 in order to discontinue the measurement of the clock period tCK.

Thus, the period during which the clock signals traverse the delay circuit chain 1 is just equal to the clock period tCK less the sum of the delay time td2 of the input buffer 3 and the delay time td1 of the clock driver 4, that is tCK - (td1+td2). The delay time reproduced by the delay circuit chain 2 is also equal to tCK - (td1+td2). The result is that just one clock time is required for the clock pulses to pass through the input buffer 3, delay circuit chain 2 and the clock driver 4 such that there is substantially no skew with respect to the external clocks.

If the circuit 9 for outputting the monitor signal D during the time the clock pulses are traveling through the input buffer 3 and the input buffer dummy 5 is constituted by a SR flipflop, and if the sum of the delay time in the clock driver 4 and that in the input dummy 5 is longer than the clock period tCK, the monitor signal D is output during the time equal to the time exceeding the clock period tCK, that is the residual of the quotient obtained on dividing the sum of the delay time td2 of the input buffer 3 and the delay time td1 of the clock driver 4, (td1+td2), by the clock period tCK, in order to halt the progress of the signal through the delay circuit chain 1 used for clock period measurement. Thus, it becomes possible to remove the clock skew even if the sum of the delay time of the input buffer and the delay time of the clock driver is longer than the clock period tCK.

In the timing chart shown in Fig.24, the monitor signal D, which halts the progress of the clock signals, monitors the time period during which the clock pulses are passing through the clock driver 4, so that, since the time of clock synchronization, the timing of travel of the clock signals through the clock driver 4 is quickened by tCK-(td1+td2).

In the fourth embodiment of the present invention, the clock signals are passed at all times through the input buffer 3, delay circuit chains 1 and 2, clock driver 4 and the input buffer dummy 5. Thus, before synchronization, the clock signals subsequently enter the delay circuit chain 1 for measurement in order to measure and reproduce the clock period tCK, whereas, during synchronization, the clock signals cause the monitor signal D to be output in order to measure the time tCK-(td1+td2).

By this reason, there are occasions wherein, as in the first and second embodiments, described above, the monitor signal may be output twice during one period by switching from the pre-synchronization state to the post-synchronization state, as in the first and second embodiments described above. It is noted that the measures used in the first and second embodiments for preventing outputting of the monitor signal D twice may be used as in the fourth embodiment of the present invention.

In the fourth embodiment of the present invention, since it is unnecessary to change the clock path, the clock path (wiring length) can be reduced to render it possible to handle clock signals of a shorter period and a higher frequency.

Reference is had to the drawings for explaining the fourth embodiment of the present invention in further detail.

Example 7

Fig.23 shows the configuration of the fourth embodiment of the present invention and Fig.24 is a timing chart for illustrating the operation of the fourth embodiment.

Referring to Fig.23, the present embodiment again has delay circuit chains 1 and 2, the specified circuit structure of which is similar to that of the above-described first to fourth examples.

In the present example, clock signals are passed at all times through an input buffer 3, delay circuit chains 1 and 2, clock driver 4 and the input buffer dummy 5. Thus, in the present embodiment, a clock monitor signal D is generated after the synchronization operation mode is entered. The internal clocks free of clock skew are generated by measuring the time of tCK - (td1+td2) by the delay circuit chain 1 and by reproducing the time of tCK - (td1+td2) by the delay circuit chain 2.

In the present example, the delay circuit chain 1 is not in operation with the second clock monitor signal D or a clock monitor signal D following the second clock monitor signal D after a first clock monitor signal D is generated (monitor signal shown by hatching in Fig.24). This evades the monitor signal D acting twice on the delay circuit chain 1 during one period to generate tCK - (td1+td2) at all times.

In the preset embodiment, the delay circuit chains 1, 2 are not limited to the linear array of delay elements. For example, these delay elements may also be arrayed in a ring so that the clock signals are rotated and the number of times of rotation may be counted by a counter. In this case, the delay circuits used in the first to fourth embodiments may be used without limitations.

Embodiment 5

As already explained with reference to Figs.25 and 26, in the conventional circuit constituting the double frequency and Duty50 generating circuit by the synchronous delay circuit, the double frequency internal clocks freed of clock skew and Duty50 clocks can be produced with the two clock periods for removing clock skew and 1.5 periods for the double frequency and the Duty50. However, with this conventional internal delay circuit, the removal of clock skew and the double frequency with Duty50 are achieved by two clock periods and 1.5 clock period in series, 3.5 clocks (3.5 tCK) are required for skew removal.

Fig.27 shows the structure of the fifth embodiment of the present invention. Fig.28 is a timing chart for illustrating the operation of the fifth embodiment of the present invention.

Referring to Fig.27, the fifth embodiment of the present invention includes, in addition to the input buffer 3, first switch 10A, clock driver 4, input dummy 5, monitor signal generating circuit 9 and the circuit configuration for skew removal comprised of the synchronous delay circuit made up of the delay circuit chain 1 for clock period measurement and the delay circuit chain 2 for clock period reproduction, a delay circuit chain 1A for measuring the pre-set time, a speed variable delay circuit chain 2A for reproducing the delay time proportionate to the measured delay time, a second switch 10B and a synthesis circuit 9A.

An output (A) of the input buffer 3 and an output (E1) of the delay circuit chain 2 for clock period reproduction are input to the second switch 10B, an output of which is coupled to the delay circuit chain 1A used for measuring the pre-set time.

An output of the delay circuit chain 2 and the speed variable delay circuit chain 2A for reproducing the delay time is input to the signal synthesis circuit 9A, an output of which is input to the first switch 10A. An output of the first switch 10A is sent to the clock driver 4 and the monitor signal generating circuit 9.

The clock period is measured by passing the clock signals through the delay circuit chain 1A used for measuring clock periods. First, the clock periods are measured by an output of the input buffer 3 and when the signal E1 is output from the delay circuit chain 2 for period reproduction, the clock period is measured with the signal from the delay circuit chain 2.

The speed variable delay circuit chain 2A adapted for reproducing the delay time proportionate to the measured delay time reproduces the delay time proportionate to the measured delay time no matter whether the delay circuit chain 1A used for measuring the period has measured the clock period by a signal from the delay circuit chain 2 selected by the second switch 10B or an output of the input buffer 3. The speed variable delay circuit chain 2A controls the output by the signal from the delay circuit chain 2. There is produced at this time a time difference during which the measurement of the clock period tCK is discontinued.

Thus, before outputting of the clock substantially free of skew with respect to the external clocks by the delay circuit chains 1 and 2 explained with reference to the above-described first to third embodiments, the clock period can be measured by the delay circuit chain 1A, so that, when the clocks free of skew are output by the delay circuit chain 2, the generated clocks can be immediately passed through the delay circuit chain 2A having the delay proportionate to the clock period.

Thus, by synthesizing an output of the delay circuit chain 2 and an output of the delay circuit chain 2A by the signal synthesis circuit 9A, it is possible to obtain internal clocks of the double frequency and Duty50 clocks substantially free from the external clocks 6 by synthesizing an output of the delay circuit chain 2 and the delay circuit chain 2A.

Reference is had to the drawings for illustrating the fifth embodiment of the present invention.

Example 8

Fig.27 shows the structure of an eighth example of the present invention and Fig.28 shows a timing chart for illustrating the operation of the eighth embodiment. Referring to Fig.27, the specified circuits of the delay circuit chains 1 and 2 and the delay circuit chains 1A and 2A can be configured similarly to those of the above-described first to fourth embodiments.

The delay time of the delay circuit chain 2A for period reproduction is just a half that of the delay circuit chain 1A for period measurement. The delay circuits of the period delay circuit chain 2A may be implemented by the number of elements, difference in driving capability and in delay time difference. Several examples of the circuit configuration are shown in Figs.29 to 32.

Referring to Fig.29, the circuit of the eighth embodiment includes a delay circuit chain 11 for measurement, a control circuit 18 for controlling the transfer to a delay circuit chain 12 for delay reproduction of clocks propagated through the delay circuit chain 11 and the delay circuit chain 12. The number of elements (delay elements made up of NANDs and inverters) per stage is equal to that of the delay circuit chain 12. Thus, the delay time of the delay circuit chain 12 for period reproduction is just a half of that of the delay circuit chain 11 for period measurement. Meanwhile, the delay circuits of the delay circuit chain 11 are configured for turning PMOS and NMOS transistors on and off based on the monitor signal D for controlling the on/off state of the NMOS transistors for controlling the active/inactive states of the delay circuits (NAND circuits and inverter circuits). The delay circuits of the delay circuit chain 12 are activated at all times.

In Fig.30, the number of loads of the delay circuits of the delay circuit chain 12 (NANDs for load adjustment) per stage is set to twice as many as that of the delay circuit chain 12.

In Fig.31, the driving capability per stage of the delay circuits of the delay circuit chain 12 is set to double that of the delay circuit chain 11. That is, two clocked inverters are connected in parallel per stage in the delay circuit chain 12. Each clocked inverter of the delay circuit chain 12 has its active or inactive state controlled by a complementary signal of a signal AA adapted for controlling the active or inactive state of the delay circuit chain 11.

In Fig.32, the driving capability per stage of the delay circuits of the delay circuit chain 12 is set to double that of the delay circuit chain 11. The delay circuit chain 11 is made up of two stages of clock inverters per stage of the delay circuit, while the delay circuit chain 12 is made up of two stages of parallel-connected clock inverters per stage of the delay circuit. In Fig.32, the PMOS and NMOS transistors (such as MP12, MN12) controlling the activation/ non-activation of the clocked inverters of the period-measurement delay circuit chain 1 have gate terminals controlled a logical product (AND) output of the monitor signal D and a frequency divided signal AA of a signal A (external clock input) and its inverted value, while the PMOS and NMOS transistors adapted for controlling the activation/ non-activation of the clocked inverters of the delay circuit chain 12 for delay reproduction have gate terminals controlled by the complementary signal of the frequency divided signal and its inverted value.

Referring to Fig. 32 again, there is provided a modified embodiment. Namely, PMOS transistors MP12 and MP12B of the first stage clocked inverter and NMOS transistors MN12 and MN12B of the second stage clocked inverter can be eliminated in the delay circuit chain 11 on the one hand. On the other hand, the parallel transistors MP13 and MP13a of the first stage clocked inverter and the parallel transistors MN13, MN13B and MN13C of the second stage clocked inverter can be eliminated. In this case, the clock signals received by the delay circuit chain 11 are driven alternately by PMOS transistors and NMOS transistors in a sequence of Fln-NMOS transistors-Fln+1- PMOS transistor- Fln+2.... Also in the delay circuit chain 12 the PMOS transistors and NMOS transistors are driven likewise alternately. In such an arrangement, the required number of elements is reduced to about a half as compared to the case of Fig. 32. A further modification is also possible. As for the clocked inverters, PMOS and NMOS transistors functioning as switch elements and constituting the CMOS inverter are disposed inside / outside with respect to the power supply Vcc and the ground line GND in Fig.32. However, these PMOS and NMOS transistors constituting the CMOS inverter may be disposed between the switching element and Vcc, and between the switching element and GND, respectively.

In a further variant, the first and second delay circuit chains, third and fourth delay circuit chains may be made up of delay circuits adapted for separately driving PMOS and NMOS transistors constituting the delay circuit of the delay circuit chains.

Although the single-phase clock signals are entered from outside in the above-described embodiments, it is possible with the present invention to use complementary clock signals as clocks 6 entered from outside and to utilize the rising and falling edges of the complementary clock signals. Since the distance traversed by the clock signals may be half the clock period, the circuit scale may be reduced.

In the system shown in Figs. 11 and 13, pulse edges are used, so that frequency division is required with the single-phase clock input. However, if complementary signals are used, the necessity of frequency division is advantageously eliminated.

It is also possible to increase the effective operating frequency by using complementary clock signals as clocks entered from outside and two sets of circuits in which rising and falling edges of the complementary clock signals are alternately used, with outputs of the circuits being complementary signals.

Example 9

A ninth example of the present invention is hereinafter explained. In the preset example, configured similarly to the above-described eighth embodiment, is decreased in the number of changeover circuits. Fig.33 shows the structure of the ninth embodiment. Referring to Fig.33, the second switch 10B (changeover unit) of Fig.27 is omitted and an output of the first switch (changeover unit) 10B is sent to the clock driver 4, monitor signal generating circuit 9 and to the delay circuit chain 1A. Outputs of the delay circuit chain 2 and the delay circuit chain 2A (having the delay time equal to 1/n of the delay circuit chain 1A for measurement) are synthesized by a signal synthesis circuit 9A, with the synthesized signal being supplied from the first switch 10 via clock driver 4 as the internal clock. In this configuration, the switch 10 first selects the external clocks from the input buffer 3 to send the internal clock signals 7 from the clock driver 4. Outputs of the input buffer 3 are sent to the delay circuit chains 1, 2 and to the delay circuit chains 1A, 2A . After synchronization, an output of the signal synthesis circuit 9A is selected.

Although the delay circuit chains 1, 2, 1A and 2A are shown linearly, these may also be arranged in a ring, as disclosed in JP Patent Kokai JP-A-8-237091, with the clock signals being rotated and the number of times of rotation thereof being then counted by a counter. In this case, any of the delay circuits shown in examples 1 to 4 may be used.

Thus, in accordance with the present invention as described above, the period of a clock is measured as the propagation time of a clock pulse or clock pulse edge, the amount of delay of a clock driver is measured by halting the propagation of a clock pulse, and a time obtained by excluding the amount of delay of the clock driver from the clock period is measured. As a result, a dummy delay circuit for the clock driver is no longer necessary.

Consequently, even if the present invention is applied to a device such as an ASIC in which the amount of clock delay differs from chip to chip, it is no longer necessary to design a clock driver dummy whenever a wiring design is changed and no longer necessary to give consideration to the layout of an area for the clock driver dummy, thereby making possible highly efficient, economical design.

Further, since a time obtained by excluding the actual clock driver delay from the clock period is measured directly, there is no longer any skew caused by a difference between the amount of delay of the clock driver dummy and the amount of delay of the original clock driver even if the delay time of driver varies owing to a variation in the temperature of the device during use. This has the effect of improving accuracy and reliability by a wide margin.

As many apparently widely different embodiments of the present invention can be made without departing from the scope thereof, it is to be understood that the invention is not limited to the specific embodiments thereof except as defined in the appended claims.

**Claims**

1. A synchronous delay circuit for controlling a clock signal, comprising:

   a first delay circuit chain (11) propagating a pulse or pulse edge therethrough for a fixed period of time; and
   a second delay circuit chain (12) capable of passing a pulse or pulse edge over a length proportional to the length of said first delay circuit chain (11) along which the pulse or pulse edge propagated; **characterized by**
   a circuit (19) for outputting a monitor signal (D) for a period of time over which a clock pulse is propagating through a clock driver;
   advance of a pulse or pulse edge being halted in said first delay circuit chain (11) during output of the monitor signal (D).

2. The circuit according to claim 1, wherein delay circuit elements constructing said first delay circuit chain are made up by clocked inverters controlled by the monitor signal.

3. A semiconductor integrated circuit device which includes a synchronous delay circuit as defined in claim 1, wherein
   a clock driver (14) outputs an internal clock signal.

4. The device according to claim 3, wherein delay circuit elements constructing said first delay circuit chain are constituted by clocked inverters controlled by the monitor signal.

5. The device according to claim 3 or 4, which comprises a switch (10) switching between an output of an input buffer (13), to which an external clock signal is applied as an input, and an output of said second delay circuit chain (12), and supplying the output to said clock driver (14).

6. The device according to claim 3, wherein said monitor signal generating circuit (19) comprises a flip-flop reset and set by an input and output, respectively, of said clock driver (14).

7. A semiconductor integrated circuit device which includes the synchronous delay circuit as defined in claim 1 as a macro, wherein
   the clock signal from said first delay circuit chain (11) is applied as an input to the second delay circuit chain (12), and
   said clock driver (14) outputs an internal clock signal, and comprising
   a switch switching (10) between an output of an input buffer (13), and an output of said second delay circuit chain (12).

8. The device according to claim 7, wherein said first delay circuit chain (11) and said second delay circuit chain (12) are arranged in opposing directions in terms of their signal propagation directions, and a clock pulse propagates through said first delay circuit chain and then enters said second delay circuit chain via a control circuit (18) when the next clock pulse is output by said input buffer (13).

9. The device according to claim 7, wherein said first delay circuit chain (11) and said second delay circuit chain (12) are arranged in opposing directions in terms of their signal propagation directions, and a clock signal propagates through said first delay circuit chain and then enters said second delay circuit chain when the next clock pulse is output by said input buffer (13).

10. The device according to claim 7, wherein said first delay circuit chain (11) and said second delay circuit chain are arranged in the same direction in terms of their signal propagation directions, a clock signal propagates through said first delay circuit chain and the output of said second delay circuit chain is selected when the next clock pulse is output by said input buffer (13).

11. The device according to claim 7, wherein said first delay circuit chain (11) and said second delay circuit chain (12) are arranged in opposing directions in terms of their signal propagation directions, a clock signal propagates through said first delay circuit chain and the output of said second delay circuit chain is selected when the next clock pulse is output by said input buffer.

12. The semiconductor integrated circuit as defined in claim 7, wherein
said switch (10) switches between the output of an input buffer (13) which receives clock signals from outside and the output of said second delay circuit (12) after first outputting of a monitoring signal (D) for said monitoring signal generating circuit (19).

13. The semiconductor integrated circuit as defined in claim 7, wherein
said switch (10) supplies the selected output to said clock driver (14), wherein
during the circuit operation, the external clock signals are first caused to travel through a path from said input buffer (13) through said switch (10) to said clock driver (14), an output of the clock driver (14) is once supplied as internal clocks and subsequently the path from the input buffer (13) to the clock driver (14) is switched to the path from said input buffer (13) to said first delay circuit chain (11), an output of said second delay circuit chain (12) being selected by said switch (10) so as to be supplied as internal clock signals through said clock driver (14).

14. The semiconductor integrated circuit as defined in claim 7, wherein control is performed to stop the next monitor signal (D) after first outputting of said monitor signal.

15. The semiconductor integrated circuit as defined in any one of claims 7 to 14 further comprising:

an input buffer dummy circuit (15) having delay time equal to that of the input buffer (13) which receives external clocks, said clock driver (14) and the input buffer dummy circuit (15) being connected in series with each other;
said monitor signal generating circuit (19) outputting monitor signals during a period of said clock signals are propagating through said clock driver (14) and the input buffer (13).

16. The semiconductor integrated circuit as defined in claim 15 further comprising
a second switch (10B) for switching between an output of said input buffer dummy circuit (5) and an output of said input buffer (3), an output of said second switch (10B) being supplied to said first delay circuit chain (1);
said second switch supplying an output of said input buffer (3) as a first clock pulse or a pulse edge entering said first delay circuit chain (1).

17. A synchronous delay circuit as claimed in claim 16, wherein
during the circuit operation, the external clock signals are first caused to travel through a path from said input buffer (3) through said first switch (10A) to said clock driver (4), an output of the clock driver is once supplied as internal clocks and subsequently clock signals from outside are caused to travel through a path from said input buffer (3) to said clock driver (4); the time corresponding to the balance of the sum $(td1+td2)$ of a delay time $(td1)$ of said input buffer (3) and a delay time $(td2)$ of the clock driver (4) subtracted from a clock period $(tCK)$ is measured by passage of the clock signals through said input buffer dummy circuit (5) and subsequently from the second switch (10B) to said first delay circuit chain (1); and
wherein as from the next clock signal, the travel path is switched from a path via the input buffer (3) and the second switch (10B), through the first delay circuit chain (1) for measurement and the second delay circuit chain (2) for delay reproduction, to a path via said first switch (10A) and said clock driver (4) for removing the skew of the external clocks and the internal clocks.

18. The semiconductor integrated circuit as defined in any one of claims 3 to 17 further comprising:

    a third delay circuit chain (1A) for allowing pulses or pulse edges to proceed for a pre-set time; and
    a fourth delay circuit chain (2A) capable of allowing the pulses or pulse edges to travel therethrough by a length proportionate to the length through which the pulses or pulse edges have proceeded in the third delay circuit chain (1A);

    wherein clocks are adapted to be halted for an optional period after being allowed to travel through the third delay circuit chain (1A).

19. The semiconductor integrated circuit as defined in claim 18 further comprising:

    a third switch (10, 10B) switching between an output of an input buffer (3) which receives external clocks and an output of the second delay circuit chain (2); an output of the third switch being entered to the third delay circuit chain (1A).

20. A synchronous delay circuit as defined in claim 1, wherein
    said first delay circuit chain allows input clock signals output from an input buffer (3) to proceed for a pre-set period;
    said second delay circuit chain (2) entering clock signals from the first delay circuit chain (1), said second delay circuit chain (2) allowing said input clock signals to pass therethrough by a length corresponding to the length of the first delay circuit chain (1) through which the clock signals traveled;
    said monitor signal generating circuit outputs said monitor signal during a period the input clock signals are traveling through the clock driver (4) outputting internal clock signals and through an input buffer dummy circuit (5) connected to said clock driver (4); and further comprising
    a third delay circuit chain (1A) allowing pulses or pulse edges to travel therethrough for a pre-set period;
    a variable-speed fourth delay circuit chain (2A) capable of allowing the pulses or pulse edges to travel therethrough by a length proportionate to the length through which the pulses or pulse edges have proceeded in said third delay circuit chain (1A);
    a signal synthesis circuit (9A) synthesizing all output of said second delay circuit chain and an output of said fourth delay circuit chain;

    a first switch (10A) to which an output of said signal synthesis circuit (9A) and an output of said input buffer (3) are entered as input, said first switch (10A) outputting one of the outputs to said clock driver (4) and said monitor signal generating circuit (9); and
    a second switch (10B) which receives an output of said input buffer (3) and an output of the second delay circuit chain (2) as input, said second switch outputting one of the outputs to an input of the third delay circuit chain (1A).

21. A synchronous delay circuit as defined in claim 1, wherein
    said first delay circuit chain allows input clock signals sent from the input buffer (3) to proceed for a pre-set period;
    said second delay circuit chain (2) which receives clock signals from said first delay circuit chain (1), said second delay circuit chain (2) allowing said input clock signals to pass therethrough by a length proportionate to the length of the first delay circuit chain (1) through which the clock signals traveled;
    said monitor signal generating circuit outputs said monitor signal during a period the input clock signals are traveling through the clock driver (4) outputting internal clock signals and through an input buffer dummy circuit (5) connected to said clock driver (4); and further comprising
    a third delay circuit chain (1A) allowing pulses or pulse edges to travel therethrough for a pre-set period;
    a variable-speed fourth delay circuit chain (2A) capable of allowing the pulses or pulse edges to travel therethrough by a length proportionate to the length through which the pulses or pulse edges proceeded in said third delay circuit chain (1A);
    a signal synthesis circuit (9A) synthesizing an output of the second delay circuit chain and an output of the fourth delay circuit chain; and
    a switch (10A) which receives an output of said signal synthesis circuit (9A) and an output of said input buffer (3), said switch (10A) outputting one of the outputs to said clock driver (4), said monitor signal generating circuit (9) and said third delay circuit chain (1A).

22. The semiconductor integrated circuit as defined in any one of claims 18 to 21, wherein the delay circuit elements of said third delay circuit chain (1A) and those of said fourth delay circuit chain (2A) are provided at a mutually different element number ratio.

23. The semiconductor integrated circuit as defined in any one of claims 18 to 21, wherein the delay circuit elements of said third delay circuit chain (1A) and those of said fourth delay circuit chain (2A) are provided at a mutually different load ratio.

24. The semiconductor integrated circuit as defined in any one of claims 18 to 21, wherein the delay circuit elements of said third delay circuit chain (1A) and those of said fourth delay circuit chain (2A) are provided at a mutually different driving capability ratio.

25. The semiconductor integrated circuit as defined in any one of claims 18 to 21, wherein said first, second, third and fourth delay circuit chains (1, 2, 1A, 2A) are made up of delay circuits adapted for separately driving PMOS and NMOS transistors constituting delay circuits of said delay circuit chains.

26. The semiconductor integrated circuit as defined in any one of claims 18 to 21, wherein said clock signal entering the delay circuit chain is divided alternately by PMOS transistors and NMOS transistors in series.

27. The semiconductor integrated circuit as defined in any one of claims 3 to 25, wherein the clock pulses or clock edges entered from outside are complementary clock signals and wherein rising or falling edges of said complementary clock signals are alternately utilized.

28. The semiconductor integrated circuit as defined in any one of claims 3 to 25, wherein the clock pulses or clock edges entered from outside are complementary clock signals and wherein there are provided two sets of circuits reciprocally utilizing one of rising or falling edges of said complementary clock signals.

29. The semiconductor integrated circuit as defined in any one of claims 3 to 28, wherein at least one of said delay circuit chains is configured so that delay elements are arrayed in a ring, clock signals are rotated, and the number of times of rotation is counted by a counter.


**Patentansprüche**

1. Synchronverzögerungsschaltung zum Steuern eines Taktsignals mit:

   einer ersten Verzögerungsschaltungskette (11), die einen Puls oder eine Pulsflanke für eine feste Zeitspanne durchleitet, und
   einer zweiten Verzögerungsschaltungskette (12), die einen Puls oder Pulsflanke über eine Länge durchlassen kann, die proportional zu der Länge der ersten Verzögerungsschaltungskette (11) ist, entlang der der Puls oder die Pulsflanke weitergeleitet wird, **gekennzeichnet durch**
   eine Schaltung (19) zum Ausgeben eines Überwachungssignals (D) für eine Zeitspanne, über der ein Taktpuls **durch** einen Takttreiber geleitet wird, wobei das Fortschreiten eines Pulses oder einer Pulskante in der ersten Verzögerungsschaltungskette (11) während der Ausgabe des Überwachungssignals (D) angehalten wird.

2. Schaltung nach Anspruch 1, wobei Verzögerungsschaltungselemente, die die erste Verzögerungsschaltungskette bilden, durch getaktete Inverter gebildet sind, die durch das Überwachungssignal gesteuert werden.

3. Integrierte Halbleiterschaltungsvorrichtung mit einer Synchronverzögerungsschaltung nach Anspruch 1, wobei ein Takttreiber (14) ein internes Taktsignal ausgibt.

4. Vorrichtung nach Anspruch 3, wobei Verzögerungsschaltungselemente, die die erste Verzögerungsschaltungskette bilden, durch getaktete Inverter gebildet sind, die durch das Überwachungssignal gesteuert werden.

5. Vorrichtung nach Anspruch 3 oder 4 mit einem Schalter (10), der zwischen einem Ausgang eines Eingabepuffers (13), an den das externe Taktsignal als Eingabe angelegt wird, und einem Ausgang der zweiten Verzögerungsschaltungskette (12) schaltet und die Ausgabe an den Takttreiber (14) liefert.

6. Vorrichtung nach Anspruch 3, wobei die Überwachungssignal-Erzeugungsschaltung (19) ein Flip-Flop aufweist, das durch eine Eingabe und eine Ausgabe des Takttreibers (14) rückgesetzt bzw. gesetzt wird.

7. Integrierte Halbleiterschaltungsvorrichtung mit der Synchronverzögerungsschaltung nach Anspruch 1 als Makro, wobei
   das Taktsignal von der ersten Verzögerungsschaltungskette (11) als eine Eingabe an die zweite Verzögerungsschaltungskette (12) angelegt wird und
   der Takttreiber (14) ein internes Taktsignal abgibt und mit
   einem Schalter (10), der zwischen einem Ausgang eines Eingangspuffers (13) und einem Ausgang der zweiten Verzögerungsschaltungskette (12) schaltet.

8. Vorrichtung nach Anspruch 7, wobei die erste Verzögerungsschaltungskette (11) und die zweite Verzögerungsschaltungskette (12) unter Berücksichtigung ihrer Signalfortpflanzungsrichtungen in entgegengesetzten Richtungen angeordnet sind und wobei ein Taktpuls durch die erste Verzögerungsschaltungskette weitergeleitet wird und anschließend in die zweite Verzögerungsschaltungskette über eine Steuerschaltung (18) gelangt, wenn der nächste Taktpuls durch den Eingangspuffer (13) ausgegeben wird.

9. Vorrichtung nach Anspruch 7, wobei die erste Verzögerungsschaltungskette (11) und die zweite Verzögerungsschaltungskette (12) im Hinblick auf ihre Signalfortpflanzungsrichtungen in entgegengesetzten Richtungen angeordnet sind und wobei ein Taktsignal durch die erste Verzögerungsschaltungskette weitergeleitet wird und dann in die zweite Verzögerungsschaltungskette gelangt, wenn der nächste Taktpuls durch den Eingangspuffer (13) ausgegeben wird.

10. Vorrichtung nach Anspruch 7, wobei die erste Verzögerungsschaltungskette (11) und die zweite Verzögerungsschaltungskette im Hinblick auf ihre Signalfortpflanzungsrichtungen in derselben Richtung angeordnet sind, wobei ein Taktsignal durch die erste Verzögerungsschaltungskette geleitet wird und der Ausgang der zweiten Verzögerungsschaltungskette ausgewählt wird, wenn der nächste Taktpuls durch den Eingangspuffer (13) ausgegeben wird.

11. Vorrichtung nach Anspruch 7, wobei die erste Verzögerungsschaltungskette (11) und die zweite Verzögerungsschaltungskette (12) im Hinblick auf ihre Signalfortpflanzungsrichtungen in entgegengesetzten Richtungen angeordnet sind, wobei ein Taktsignal durch die erste Verzögerungsschaltungskette geleitet wird und der Ausgang der zweiten Verzögerungsschaltungskette ausgewählt wird, wenn der nächste Taktpuls durch den Eingangspuffer ausgegeben wird.

12. Integrierte Halbleiterschaltung nach Anspruch 7, wobei der Schalter (10) nach der ersten Ausgabe eines Überwachungssignals (D) für die Überwachungssignal-Erzeugungsschaltung (19) zwischen dem Ausgang eines Eingangspuffers (13), der Taktsignale von außerhalb erhält, und dem Ausgang der zweiten Verzögerungsschaltung (12) schaltet.

13. Integrierte Halbleiterschaltung nach Anspruch 7, wobei der Schalter (10) die ausgewählte Ausgabe an den Takttreiber (14) liefert, wobei während des Schaltungsbetriebs die externen Taktsignale veranlasst werden, durch einen Pfad von dem Eingangspuffer (13) durch den Schalter (10) bis zu dem Takttreiber (14) zu laufen, wobei eine Ausgabe des Takttreibers (14) einmalig als interne Takte geliefert wird und anschließend der Pfad von dem Eingangspuffer (13) zum Takttreiber (14) geschaltet wird zu dem Pfad von dem Eingangspuffer (13) zu der ersten Verzögerungsschaltungskette (11), wobei eine Ausgabe der zweiten Verzögerungsschaltungskette (12) durch den Schalter (10) so ausgewählt wird, dass sie als interne Taktsignale durch den Takttreiber (14) geliefert werden.

14. Integrierte Halbleiterschaltung nach Anspruch 7, wobei die Steuerung durchgeführt wird, um das nächste Überwachungssignal (D) nach dem ersten Ausgeben des Überwachungssignals, zu stoppen.

15. Integrierte Halbleiterschaltung nach einem der Ansprüche 7 bis 14 mit ferner:

> einer Eingabepuffer-Dummyschaltung (15) mit einer Verzögerungszeit, die gleich der des Eingangspuffers (13) ist, der externe Taktsignale erhält, wobei der Takttreiber (14) und die Eingangspuffer-Dummyschaltung (15) in Reihe miteinander geschaltet sind,

> wobei die Überwachungssignal-Erzeugungsschaltung (19) Überwachungssignale während einer Spanne ausgibt, in der Taktsignale durch den Takttreiber (14) und den Eingangspuffer (13) weitergeleitet werden.

16. Integrierte Halbleiterschaltung nach Anspruch 15 mit ferner:

> einem zweiten Schalter (10B) zum Schalten zwischen einer Ausgabe der Eingangspuffer-Dummyschaltung (5) und einer Ausgabe des Eingangspuffers (3), wobei die Ausgabe des zweiten Schalters (10B) an die erste Verzögerungsschaltungskette (1) geliefert wird,

> wobei der zweite Schalter eine Ausgabe des Eingangspuffers (3) als einen ersten Taktpuls oder als eine Pulsflanke ausgibt, die in die erste Verzögerungsschaltungskette (1) gelangt.

17. Synchronverzögerungsschaltung nach Anspruch 16, wobei während des Schaltungsbetriebs zunächst verursacht wird, dass die externen Taktsignale durch einen Pfad von dem Eingangspuffer (3) durch den ersten Schalter (10A) zu dem Takttreiber (4) laufen, wobei die Ausgabe des Takttreibers einmalig als interne Takte geliefert wird und anschließend Taktsignale von ausserhalb dazu veranlasst werden, durch einen Pfad von dem Eingangspuffer (3) zu dem Takttreiber (4) zu laufen, wobei die Zeit entsprechend dem Unterschied der Summe (td1 + td2) einer Verzögerungszeit (td1) des Eingangspuffers (3) und einer Verzögerungszeit (td2) des Takttreibers (4), die von einer Taktzeitspanne (tCK) abgezogen wird, durch Durchlauf der Taktsignale durch die Eingangspuffer-Dummyschaltung (5) und anschließend von dem zweiten Schalter (10B) zu der ersten Verzögerungsschaltungskette (1) gemessen wird, und

wobei vom nächsten Taktsignal an der Verlaufspfad geschaltet wird, von einem Pfad über den Eingangspuffer (3) und den zweiten Schalter (10B), durch die erste Verzögerungsschaltungskette (1) für die Messung und die zweite Verzögerungsschaltungskette (2) für die Verzögerungsreproduktion, zu einem Pfad über den ersten Schalter (10A) und dem Takttreiber (4) zum Entfernen des Versatzes der internen Takte und der externen Takte.

18. Integrierte Halbleiterschaltung nach einem der Ansprüche 3 bis 17 mit ferner:

einer dritten Verzögerungsschaltungskette (1A) zum Ermöglichen, dass Pulse oder Pulsflanken für eine Vorgabezeit fortschreiten, und einer vierten Verzögerungsschaltungskette (2A), die es ermöglicht, dass die Pulse oder Pulskanten durch eine Länge durchlaufen, die proportional ist zu der Länge, durch die die Pulse oder Pulskanten in der dritten Verzögerungsschaltungskette (1A) durchgelaufen sind,

wobei Takte für eine optionale Zeitspanne angehalten werden können, nachdem ihnen ermöglicht wurde, durch die dritte Verzögerungsschaltungskette (1A) durchzulaufen.

19. Integrierte Halbleiterschaltung nach Anspruch 18 mit ferner:

einem dritten Schalter (10, 10B), der zwischen einem Ausgang eines Eingangspuffers (3), der externe Takte erhält, und einem Ausgang der zweiten Verzögerungsschaltungskette (2) schaltet, wobei eine Ausgabe des dritten Schalters in die dritte Verzögerungsschaltungskette (1A) eintritt.

20. Synchronverzögerungsschaltung nach Anspruch 1, wobei

die erste Verzögerungsschaltungskette es ermöglicht, dass Eingangstaktsignale, die von dem Eingangspuffer (3) ausgegeben werden, für eine Vorgabezeitspanne fortschreiten,

wobei die zweite Verzögerungsschaltungskette (3) Taktsignale von der ersten Verzögerungsschaltungskette (1) eingibt, die zweite Verzögerungsschaltungskette (2) es den eingegebenen Taktsignalen ermöglicht sie in einer Länge zu passieren, die der Länge der ersten Verzögerungsschaltungskette (1) entspricht, durch die die Signale durchgelaufen sind,

wobei die Überwachungssignalerzeugungsschaltung das Überwachungssignal während einer Zeitspanne ausgibt, in der die Eingabetaktsignale durch den Takttreiber (4) durchlaufen, interne Taktsignale ausgibt und durch eine Eingangspuffer-Dummyschaltung (5), die mit dem Takttreiber (4) verbunden ist, und mit ferner

einer dritten Verzögerungsschaltungskette (1A), die es ermöglicht, dass Pulse oder Pulskanten für eine Vorgabezeitspanne durchlaufen,

einer vierten Verzögerungsschaltungskette (2A) mit variabler Geschwindigkeit, die es ermöglicht, dass Pulse oder Pulskanten durch eine Länge durchlaufen, die proportional ist zu der Länge, durch welche die Pulse oder Pulskanten die dritte Verzögerungsschaltungskette (1A) durchlaufen haben,

einer Signalsyntheseschaltung (9A), die alle Ausgaben der zweiten Verzögerungsschaltungskette und eine Ausgabe der vierten Verzögerungsschaltungskette synthetisiert,

einem ersten Schalter (10A), an dem eine Ausgabe der Signalsyntheseschaltung (9A) und eine Ausgabe des Eingangspuffers (3) als Eingabe eingegeben werden, wobei der erste Schalter (10A) eine der Eingaben an den Takttreiber (4) und die Überwachungssignal-Erzeugungsschaltung (9) ausgibt, und

einem zweiten Schalter (10B), der eine Ausgabe des Eingangspuffers (3) und einer Ausgabe der zweiten Verzögerungsschaltung (2) als Eingabe empfängt, wobei der zweite Schalter eine der Ausgaben als eine Eingabe der dritten Verzögerungsschaltungskette (1A) ausgibt.

21. Synchronverzögerungsschaltung nach Anspruch 1, wobei

die erste Verzögerungsschaltungskette es Eingangstaktsignalen ermöglicht, die von dem Eingangspuffer (3) gesendet wurden, für eine Vorgabezeitspanne fortzuschreiten,

die zweite Verzögerungsschaltungskette (2) die Taktsignale von der ersten Verzögerungsschaltungskette (1) empfängt, wobei die zweite Verzögerungsschaltungskette (2) es Eingangstaktsignalen ermöglicht, für eine Länge zu passieren, die proportional zu der Länge der ersten Verzögerungsschaltungskette (1) ist, durch die die Taktsignale gelaufen sind,

wobei die Überwachungssignalerzeugungsschaltung das Überwachungssignal während einer Zeitspanne ausgibt, in der die Eingangstaktsignale durch den Takttreiber (4) laufen, der interne Taktsignale ausgibt, und durch eine Eingangspuffer-Dummyschaltung (5), die mit dem Takttreiber (4) verbunden ist, und mit ferner

einer dritten Verzögerungsschaltungskette (1A), die es ermöglicht, dass Pulse oder Pulsflanken sie für eine Vorgabezeitspanne durchlaufen, einer vierten Verzögerungsschaltungskette (2A) mit variabler Geschwindigkeit, die es ermöglichen kann, dass Pulse oder Pulsflanken durch sie für eine Länge verlaufen, die proportional zu der Länge ist, durch die die Pulse oder Pulsflanken in der dritten Verzögerungsschaltungskette (1A) fortschreiten,

einer Signalsyntheseschaltung (9A), die eine Ausgabe der zweiten Verzögerungsschaltungskette und eine Ausgabe der vierten Verzögerungsschaltungskette synthetisiert, und

einem Schalter, der eine Ausgabe der Signalsyntheseschaltung (9A) und eine Ausgabe des Eingabepuffers (3) erhält, wobei der Schalter (10A) eine der Ausgaben an den Takttreiber (4), die Überwachungssignal-Erzeugungsschaltung (9) und die dritte Verzögerungschaltungskette (1A) ausgibt.

22. Integrierte Halbleiterschaltung nach einem der Ansprüche 18 bis 21, wobei die Verzögerungsschaltungselemente der dritten Verzögerungsschaltungskette (1A) und die der vierten Verzögerungsschaltungskette (2A) in einem gegenseitig unterschiedlichen Elementzahlverhältniss vorgesehen sind.

23. Integrierte Halbleiterschaltung nach einem der Ansprüche 18 - 21, wobei die Verzögerungsschaltungselemente der dritten Verzögerungsschaltungskette (1A) und die der vierten Verzögerungsschaltungskette (2A) mit einem gegenseitig unterschiedlichen Lastverhältniss vorgesehen sind.

24. Integrierte Halbleiterschaltung nach einem der Ansprüche 18 bis 21, wobei die Verzögerungsschaltungselemente der dritten Verzögerungsschaltungskette (1A) und der vierten Verzögerungsschaltungskette (2A) in einem gegenseitig unterschiedlichen Treiberkapazitätsverhältniss vorgesehen sind.

25. Integrierte Halbleiterschaltung nach einem der Ansprüche 18 bis 21, wobei die erste, die zweite, die dritte und die vierte Verzögerungsschaltungskette (1, 2, 1A, 2A) aus Verzögerungsschaltungen aufgebaut sind, die für separate Treiber von PMOS- und NMOS-Transistoren angepasst sind, die Verzögerungsschaltungen der Verzögerungsschaltungsketten bilden.

26. Integrierte Halbleiterschaltung nach einem der Ansprüche 18 bis 21, wobei das Taktsignal, das in die Verzögerungsschaltungskette eintritt, abwechselnd durch PMOS-Transistoren und NMOS-Transistoren in Reihe geteilt wird.

27. Integrierte Halbleiterschaltung nach einem der Ansprüche 3 bis 25, wobei die Taktpulse oder Taktflanken, die von außen eindringen, komplementäre Taktsignale sind und wobei ansteigende oder abfallende Flanken der komplementären Taktsignale abwechselnd ausgenutzt werden.

28. Integrierte Halbleiterschaltung nach einem der Ansprüche 3 bis 25, wobei die Taktpulse oder Taktflanken, die von außen eintreten, komplementäre Taktsignale sind und wobei zwei Sätze von Schaltungen vorgesehen sind, die reziprok eine ansteigende oder abfallende Flanke der komplementären Taktsignale verwenden.

29. Integrierte Halbleiterschaltung nach einem der Ansprüche 8 bis 21, wobei zumindest eine der Verzögerungsschaltungsketten so konfiguriert ist, dass Verzögerungselemente in einem Ring aufgereiht sind, Taktsignale rotieren und die Anzahl der Male der Rotation durch einen Zähler gezählt wird.

**Revendications**

1. Circuit à retard synchrone destiné à commander un signal d'horloge, comprenant :

une première chaîne de circuits à retard (11) propageant une impulsion ou un front d'impulsion à travers elle pendant une période de temps fixée ; et
une seconde chaîne de circuits à retard (12) apte à faire passer une impulsion ou un front d'impulsion avec une longueur proportionnelle à la longueur de ladite première chaîne de circuits à retard (11) le long de laquelle l'impulsion ou le front d'impulsion se sont propagés ; **caractérisé par**
un circuit (19) destiné à délivrer un signal de contrôle (D) au cours d'une période de temps pendant laquelle une impulsion d'horloge se propage à travers un circuit pilote d'horloge ;
une avance d'une impulsion ou d'un front d'impulsion étant cessée dans ladite première chaîne de circuits à retard (11) au cours de la délivrance du signal de contrôle (D).

2. Circuit selon la revendication 1, dans lequel les éléments de circuit à retard constituant ladite première chaîne de circuits à retard sont composés d'inverseurs cadencés commandés par le signal de contrôle.

3. Dispositif de circuit intégré à semi-conducteur, qui inclut un circuit à retard synchrone selon la revendication 1, dans lequel
un circuit pilote d'horloge (14) délivre un signal d'horloge interne.

**4.** Dispositif selon la revendication 3, dans lequel les éléments de circuit à retard constituant ladite première chaîne de circuits à retard sont composés d'inverseurs cadencés commandés par le signal de contrôle.

**5.** Dispositif selon la revendication 3 ou 4, qui comprend un commutateur (10) commutant entre un signal de sortie d'un circuit tampon d'entrée (13), auquel un signal d'horloge externe est appliqué en tant que signal d'entrée, et un signal de sortie de ladite seconde chaîne de circuits à retard (12), et délivrant le signal de sortie audit circuit pilote d'horloge (14).

**6.** Dispositif selon la revendication 3, dans lequel ledit circuit générateur de signaux de contrôle (19) comprend une bascule flip-flop mise à zéro et à un par un signal d'entrée et un signal de sortie, respectivement, dudit circuit pilote d'horloge (14).

**7.** Dispositif de circuit intégré à semi-conducteur, qui inclut le circuit à retard synchrone selon la revendication 1 en tant que macrobloc, dans lequel

le signal d'horloge provenant de ladite première chaîne de circuits à retard (11) est appliqué en tant que signal d'entrée à la seconde chaîne de circuits à retard (12), et

ledit circuit pilote d'horloge (14) délivre un signal d'horloge interne, et comprenant

un commutateur (10) commutant entre un signal de sortie d'un circuit tampon d'entrée (13) et un signal de sortie de ladite seconde chaîne de circuits à retard (12).

**8.** Dispositif selon la revendication 7, dans lequel ladite première chaîne de circuits à retard (11) et ladite seconde chaîne de circuits à retard (12) sont configurées suivant des directions opposées en termes de leur direction de propagation de signal, et une impulsion d'horloge se propage à travers ladite première chaîne de circuits à retard puis entre dans ladite seconde chaîne de circuits à retard via un circuit de commande (18) lorsque l'impulsion d'horloge suivante est délivrée par ledit circuit tampon d'entrée (13).

**9.** Dispositif selon la revendication 7, dans lequel ladite première chaîne de circuits à retard (11) et ladite seconde chaîne de circuits à retard (12) sont configurées suivant des directions opposées en termes de leur direction de propagation de signal, et un signal d'horloge se propage à travers ladite première chaîne de circuits à retard puis entre dans ladite seconde chaîne de circuits à retard lorsque l'impulsion d'horloge suivante est délivrée par ledit circuit tampon d'entrée (13).

**10.** Dispositif selon la revendication 7, dans lequel ladite première chaîne de circuits à retard (11) et ladite seconde chaîne de circuits à retard sont configurées suivant une même direction en termes de leur direction de propagation de signal, un signal d'horloge se propage à travers ladite première chaîne de circuits à retard et le signal de sortie de ladite seconde chaîne de circuits à retard est sélectionné lorsque l'impulsion d'horloge suivante est délivrée par ledit circuit tampon d'entrée (13).

**11.** Dispositif selon la revendication 7, dans lequel ladite première chaîne de circuits à retard (11) et ladite seconde chaîne de circuits à retard (12) sont configurées suivant des directions opposées en termes de leur direction de propagation de signal, un signal d'horloge se propage à travers ladite première chaîne de circuits à retard et le signal de sortie de ladite seconde chaîne de circuits à retard est sélectionné lorsque l'impulsion d'horloge suivante est délivrée par ledit circuit tampon d'entrée.

**12.** Circuit intégré à semi-conducteur selon la revendication 7, dans lequel

ledit commutateur (10) commute entre le signal de sortie d'un circuit tampon d'entrée (13), qui reçoit des signaux d'horloge provenant de l'extérieur, et le signal de sortie dudit second circuit à retard (12) après la délivrance préalable d'un signal de contrôle (D) pour ledit circuit générateur de signaux de contrôle (19).

**13.** Circuit intégré à semi-conducteur selon la revendication 7, dans lequel

ledit commutateur (10) applique le signal de sortie sélectionné audit circuit pilote d'horloge (14), dans lequel

au cours de la mise en oeuvre du circuit, les signaux d'horloge externes sont d'abord amenés à se propager sur un trajet menant dudit circuit tampon d'entrée (13) audit circuit pilote d'horloge (14), en passant par ledit commutateur (10), un signal de sortie du circuit pilote d'horloge (14) est appliqué, à une reprise, en tant que signaux d'horloge internes et, ensuite, le trajet menant du circuit tampon d'entrée (13) au circuit pilote d'horloge (14) est commuté sur le trajet menant dudit circuit tampon d'entrée (13) à ladite première chaîne de circuits à retard (11), un signal de sortie de ladite seconde chaîne de circuits à retard (12) étant sélectionné par ledit commutateur (10) de manière à être appliqué en tant que signaux d'horloge internes à travers ledit circuit pilote d'horloge (14).

**14.** Circuit intégré à semi-conducteur selon la revendication 7, dans lequel la commande est exercée pour interrompre le signal de contrôle suivant (D) après la délivrance préalable dudit signal de contrôle.

**15.** Circuit intégré à semi-conducteur selon l'une quelconque des revendications 7 à 14, comprenant, en outre :

un circuit tampon d'entrée fictif (15) présentant un temps de retard égal à celui du circuit tampon d'entrée (13) qui reçoit les signaux d'horloge externes, ledit circuit pilote d'horloge (14) et le circuit tampon d'entrée fictif (15) étant connectés en série l'un avec l'autre ;
ledit circuit générateur de signaux de contrôle (19) délivrant des signaux de contrôle au cours d'une période de temps pendant laquelle lesdits signaux d'horloge se propagent à travers ledit circuit pilote d'horloge (14) et le circuit tampon d'entrée (13).

**16.** Circuit intégré à semi-conducteur selon la revendication 15, comprenant, en outre
un second commutateur (10B) destiné à commuter entre un signal de sortie dudit circuit tampon d'entrée fictif (5) et un signal de sortie dudit circuit tampon d'entrée (3), un signal de sortie dudit second commutateur (10B) étant appliqué à ladite première chaîne de circuits à retard (1) ;
ledit second commutateur appliquant un signal de sortie dudit circuit tampon d'entrée (3) en tant que première impulsion d'horloge ou premier front d'impulsion entrant dans ladite première chaîne de circuits à retard (1).

**17.** Circuit à retard synchrone selon la revendication 16, dans lequel
au cours de la mise en oeuvre du circuit, les signaux d'horloge externes sont d'abord amenés à se propager sur un trajet menant dudit circuit tampon d'entrée (3) audit circuit pilote d'horloge (4), en passant par ledit premier commutateur (10A), un signal de sortie du circuit pilote d'horloge (4) est appliqué, à une reprise, en tant que signaux d'horloge internes et, ensuite, des signaux d'horloge provenant de l'extérieur sont amenés à se propager sur un trajet menant dudit circuit tampon d'entrée (3) audit circuit pilote d'horloge (4) ; la durée correspondant au solde de la somme (td1+td2), d'un temps de retard (td1) dudit circuit tampon d'entrée (3) et d'un temps de retard (td2) du circuit pilote d'horloge (4), soustraite d'une période d'horloge (tCK), est mesurée par le passage des signaux d'horloge à travers ledit circuit tampon d'entrée fictif (5) et, ensuite, du second commutateur (10B) à ladite première chaîne de circuits à retard (1) ; et
dans lequel, à partir du signal d'horloge suivant, le trajet de propagation est commuté d'un trajet via le circuit tampon d'entrée (3) et le second commutateur (10B), en passant par la première chaîne de circuits à retard (1), pour la mesure, et la seconde chaîne de circuits à retard (2), pour la reproduction des retards, sur un trajet via ledit premier commutateur (10A) et ledit circuit pilote d'horloge (4) afin de supprimer le déphasage des signaux d'horloge externes et des signaux d'horloge internes.

**18.** Circuit intégré à semi-conducteur selon l'une quelconque des revendications 3 à 17, comprenant, en outre :

une troisième chaîne de circuits à retard (1A) permettant à des impulsions ou à des fronts d'impulsions de s'exercer pendant une durée préfixée ; et
une quatrième chaîne de circuits à retard (2A) apte à laisser les impulsions ou les fronts d'impulsions se propager à travers elle, avec une longueur proportionnelle à la longueur avec laquelle les impulsions ou les fronts d'impulsions se sont exercées dans la troisième chaîne de circuits à retard (1A),

dans lequel les signaux d'horloge sont conçus pour être interrompus pendant une période optionnelle après avoir pu se propager à travers la troisième chaîne de circuits à retard (1A).

**19.** Circuit intégré à semi-conducteur selon la revendication 18, comprenant, en outre
un troisième commutateur (10, 10B) commutant entre un signal de sortie d'un circuit tampon d'entrée (3), qui reçoit des signaux d'horloge externes, et un signal de sortie de la seconde chaîne de circuits à retard (2) ; un signal de sortie du troisième commutateur étant entré dans la troisième chaîne de circuits à retard (1A).

**20.** Circuit à retard synchrone selon la revendication 1, dans lequel
ladite première chaîne de circuits à retard permet aux signaux d'horloge d'entrée délivrés par un circuit tampon d'entrée (3) de s'exercer pendant une période préfixée ;
ladite seconde chaîne de circuits à retard (2) entrant les signaux d'horloge provenant de la première chaîne de circuits à retard (1), ladite seconde chaîne de circuits à retard (2) laissant lesdits signaux d'horloge d'entrée passer à travers elle, avec une longueur correspondant à la longueur de la première chaîne de circuits à retard (1) avec laquelle les signaux d'horloge se sont propagés ;
ledit circuit générateur de signaux de contrôle délivre ledit signal de contrôle au cours d'une période de temps pendant laquelle les signaux d'horloge d'entrée se propagent à travers le circuit pilote d'horloge (4) délivrant les signaux d'horloge internes et à travers un circuit tampon d'entrée fictif (5) connecté audit circuit pilote d'horloge (4) ; et comprenant, en outre

une troisième chaîne de circuits à retard (1A) permettant à des impulsions ou à des fronts d'impulsions de se propager à travers elle pendant une période préfixée ;

une quatrième chaîne de circuits à retard à vitesse variable (2A) apte à laisser les impulsions ou les fronts d'impulsions se propager à travers- elle, avec une longueur proportionnelle à la longueur avec laquelle les impulsions ou les fronts d'impulsions se sont exercés dans ladite troisième chaîne de circuits à retard (1A) ;

un circuit de synthèse de signaux (9A) synthétisant un signal de sortie de ladite seconde chaîne de circuits à retard et un signal de sortie de ladite quatrième chaîne de circuits à retard ;

un premier commutateur (10A) auquel un signal de sortie dudit circuit de synthèse de signaux (9A) et un signal de sortie dudit circuit tampon d'entrée (3) sont entrés en tant que signal d'entrée, ledit premier commutateur (10A) délivrant l'un des signaux de sortie audit circuit pilote d'horloge (4) et audit circuit générateur de signaux de contrôle (9) ; et

un second commutateur (10B) qui reçoit un signal de sortie dudit circuit tampon d'entrée (3) et un signal de sortie de ladite seconde chaîne de circuits à retard (2) en tant que signal d'entrée, ledit second commutateur délivrant l'un des signaux de sortie à une entrée de la troisième chaîne de circuits à retard (1A).

**21.** Circuit à retard synchrone selon la revendication 1, dans lequel

ladite première chaîne de circuits à retard permet aux signaux d'horloge d'entrée délivrés par un circuit tampon d'entrée (3) de s'exercer pendant une période préfixée ;

ladite seconde chaîne de circuits à retard (2) entrant les signaux d'horloge provenant de ladite première chaîne de circuits à retard (1), ladite seconde chaîne de circuits à retard (2) laissant lesdits signaux d'horloge d'entrée passer à travers elle, avec une longueur proportionnelle à la longueur de la première chaîne de circuits à retard (1) avec laquelle les signaux d'horloge se sont propagés ;

ledit circuit générateur de signaux de contrôle délivre ledit signal de contrôle au cours d'une période de temps pendant laquelle les signaux d'horloge d'entrée se propagent à travers le circuit pilote d'horloge (4) délivrant les signaux d'horloge internes et à travers un circuit tampon d'entrée fictif (5) connecté audit circuit pilote d'horloge (4) ; et comprenant, en outre

une troisième chaîne de circuits à retard (1A) permettant à des impulsions ou à des fronts d'impulsions de se propager à travers elle pendant une période préfixée ;

une quatrième chaîne de circuits à retard à vitesse variable (2A) apte à laisser les impulsions ou les fronts d'impulsions se propager à travers elle, avec une longueur proportionnelle à la longueur avec laquelle les impulsions ou les fronts d'impulsions se sont exercées dans ladite troisième chaîne de circuits à retard (1A) ;

un circuit de synthèse de signaux (9A) synthétisant un signal de sortie de ladite seconde chaîne de circuits à retard et un signal de sortie de la quatrième chaîne de circuits à retard ; et

un commutateur (10A) qui reçoit un signal de sortie dudit circuit de synthèse de signaux (9A) et un signal de sortie dudit circuit tampon d'entrée (3), ledit 'commutateur (10A) délivrant l'un des signaux de sortie audit circuit pilote d'horloge (4), audit circuit générateur de signaux de contrôle (9) et à ladite troisième chaîne de circuits à retard (1A).

**22.** Circuit intégré à semi-conducteur selon l'une quelconque des revendications 18 à 21, dans lequel les éléments de circuit à retard de ladite troisième chaîne de circuits à retard (1A) et ceux de ladite quatrième chaîne de circuits à retard (2A) sont présents selon un rapport de nombres d'éléments mutuellement différents.

**23.** Circuit intégré à semi-conducteur selon l'une quelconque des revendications 18 à 21, dans lequel les éléments de circuit à retard de ladite troisième chaîne de circuits à retard (1A) et ceux de ladite quatrième chaîne de circuits à retard (2A) sont présents selon un rapport de charges mutuellement différentes.

**24.** Circuit intégré à semi-conducteur selon l'une quelconque des revendications 18 à 21, dans lequel les éléments de circuit à retard de ladite troisième chaîne de circuits à retard (1A) et ceux de ladite quatrième chaîne de circuits à retard (2A) sont présents selon un rapport de capacités d'attaque mutuellement différentes.

**25.** Circuit intégré à semi-conducteur selon l'une quelconque des revendications 18 à 21, dans lequel lesdites première, seconde, troisième et quatrième chaînes de circuits à retard (1, 2, 1A, 2A) sont composées de circuits à retard conçus pour attaquer séparément des transistors PMOS et NMOS constituant les circuits à retard desdites chaînes de circuits à retard.

**26.** Circuit intégré à semi-conducteur selon l'une quelconque des revendications 18 à 21, dans lequel ledit signal d'horloge entrant dans la chaîne de circuits à retard est divisé, en alternance, par des transistors PMOS et des transistors NMOS en série.

27. Circuit intégré à semi-conducteur selon l'une quelconque des revendications 3 à 25, dans lequel les impulsions d'horloge ou les fronts d'horloge entrés de l'extérieur sont des signaux d'horloge complémentaires, et dans lequel les fronts montants ou descendants desdits signaux d'horloge complémentaires sont utilisés en alternance.

28. Circuit intégré à semi-conducteur selon l'une quelconque des revendications 3 à 25, dans lequel les impulsions d'horloge ou les fronts d'horloge entrés de l'extérieur sont des signaux d'horloge complémentaires, et dans lequel sont présents deux ensembles de circuits utilisant, réciproquement, l'un des fronts montants ou descendants desdits signaux d'horloge complémentaires.

29. Circuit intégré à semi-conducteur selon l'une quelconque des revendications 3 à 28, dans lequel au moins l'une desdites chaînes de circuits à retard est configurée de telle sorte que les éléments à retard sont groupés suivant un anneau, les signaux d'horloge font l'objet d'une rotation et le nombre de rotations est compté par un compteur.

# FIG. 1

(a)

(b)

(c)

DRIVER USE TIMING

# F I G .  2

tCK

td1    td1    td2    tV=tCK-(td1+td2)

13; INPUT BUFFER

16; EXTERNAL CLOCK

10    14; CLOCK DRIVER

A    B  → 17; INTERNAL CLOCK

19; MONITOR SIGNAL GENERATING CIRCUIT

C

S
R

D

15; INPUT BUFFER DUMMY

td1

11; DELAY CIRCUIT CHAIN

CONTROL CIRCUIT CHAIN

18

12; DELAY CIRCUIT CHAIN

E

EP 0 896 432 B1

# FIG. 3

11 ; DELAY CIRCUIT CHAIN

18 ; CONTROL CIRCUIT

12 ; DELAY CIRCUIT CHAIN

# F I G. 4

EP 0 896 432 B1

**16;**
**EXTERNAL**
**CLOCK**
**INPUT**
**13; BUFFER**

**14; CLOCK DRIVER**

**INTERNAL CLOCK**

**A**

**SWITCH**

**C**

**S**
**R**

**19**

**D**

**td1**

**11; DELAY CIRCUIT CHAIN**

**15; INPUT BUFFER DUMMY**

**18; CONTROL CIRCUIT CHAIN**

**E**

**12; DELAY CIRCUIT CHAIN**

**20; SYNCHRONOUS DELAY CIRCUIT MACRO**

# F I G . 5

INTERNAL CLOCK

CLOCK DRIVER

SYNCHRONOUS DELAY
~20 ; CIRCUIT MACRO

INPUT BUFFER CLOCK

INPUT BUFFER
DUMMY CLOCK

EXTERNAL CLOCK

CHIP A

INTERNAL CLOCK

CLOCK DRIVER

SYNCHRONOUS DELAY
~20 ; CIRCUIT MACRO

INPUT BUFFER
CLOCK

INPUT BUFFER
DUMMY CLOCK

EXTERNAL CLOCK

CHIP B

# F I G. 6

EP 0 896 432 B1

FIG. 7

# F I G. 8

tCK

td1 td2 tV=tCK-(td1+td2)

td1

INPUT 10
13;BUFFER 14;CLOCK DRIVER
16;EXTERNAL CLOCK
17;INTERNAL CLOCK
15;INPUT BUFFER DUMMY
24;1/2 FREQUENCY DIVIDER

11;DELAY CIRCUIT CHAIN
12;DELAY CIRCUIT CHAIN
11;DELAY CIRCUIT CHAIN
12;DELAY CIRCUIT CHAIN

# F I G. 9

EP 0 896 432 B1

FIG. 10

EP 0 896 432 B1

# FIG. 11

905 ;DUMMY DELAY CIRCUIT

903 ;INPUT BUFFER

906 ;EXTERNAL CLOCK

901 ;DELAY CIRCUIT CHAIN

905A ;INPUT BUFFER DUMMY

905B ; CLOCK DRIVER-DUMMY

904 ;CLOCK DRIVER

907 ;INTERNAL CLOCK

902 ;DELAY CIRCUIT CHAIN

FIG. 12

# F I G. 1 3

905A; INPUT BUFFER DUMMY

905; DUMMY DELAY CIRCUIT

INPUT
903; BUFFER

905B; CLOCK DRIVER DUMMY

901; DELAY CIRCUIT CHAIN

LATCH CIRCUIT CHAIN

902; DELAY CIRCUIT CHAIN

SWITCH

907; INTERNAL CLOCK

904; CLOCK DRIVER

# FIG. 14

(a)

906; EXTERNAL CLOCK → 907; INTERNAL CLOCK

903; INPUT BUFFER  904; CLOCK DRIVER

(b)

EXTERNAL
906; CLOCK

A

907; INTERNAL CLOCK

EP 0 896 432 B1

# FIG. 15

(a)

INPUT
903; BUFFER
905; DUMMY DELAY CIRCUIT

906; EXTERNAL CLOCK

905A; INPUT BUFFER DUMMY

905B; CLOCK DRIVER-DUMMY

901; DELAY CIRCUIT CHAIN
902; DELAY CIRCUIT CHAIN

907; INTERNAL CLOCK

904; CLOCK DRIVER

$tv=tck-(td1+td2)$

(b)

906; EXTERNAL CLOCK

A

B

MEASUREMENT INTERVALS

SYNCHRONOUS DELAY INTERVALS

C

907; INTERNAL CLOCK

EP 0 896 432 B1

# FIG. 16

(a)

DELAY CHARACTERISTIC OF
CLOCK DRIVER DUMMY

DELAY CHARACTERISTIC
OF CLOCK DRIVER

DELAY TIME

POWER SUPPLY VOLTAGE

(b)

DELAY CHARACTERISTIC OF
CLOCK DRIVER DUMMY

DELAY CHARACTERISTIC
OF CLOCK DRIVER

DELAY TIME

TEMPERATURE

# FIG. 17

3;INPUT BUFFER
.4;CLOCK DRIVER
5;INPUT BUFFER DUMMY
6;OUTER CLOCKS
7;INTERNAL CLOCKS
8;SYNCHRONIZATION DELAY CIRCUIT MACRO
9;MONITOR SIGNAL GENEERATING CIRCUIT

FIG. 18

SMOACT

OUTER CLOCKS 6

INTERNAL CLOCKS 7

MEASURING CESSATION PERIOD

MEASURING PERIOD

SYNCHRONIZATION DELAY PERIOD

A
B
C
D
E

tCK    tCK

td1

tV    tV    tV    tV
tV    tV    tV

first cycle

BEFORE SYNCHRONIZATION

AFTER SYNCHRONIZATION

DRIVER USE TIMING

# FIG. 19

3;INPUT BUFFER
4;CLOCK DRIVER
5;INPUT BUFFER DUMMY
6;OUTER CLOCKS
7;INTERNAL CLOCKS
8;SYNCHRONIZATION DELAY CIRCUIT MACRO
9;MONITOR SIGNAL GENERATING CIRCUIT

# FIG. 20

SMDACT

OUTER CLOCKS 6

INTERNAL CLOCKS 7

MEASURING CESSATION PERIOD

MEASURING PERIOD

SYNCHRONIZATION DELAY PERIOD

tCK  tCK

td1  td1  td2

A  B  C  D  E

tV  tV  tV  tV  tV  tV

first cycle

BEFORE SYNCHRONIZATION

AFTER SYNCHRONIZATION

DRIVER USE TIMING

EP 0 896 432 B1

# FIG. 21

tCK

td1 | td2 | td1

$tV=tCK-(td1+td2)$

S M D A C T - -

3

6

A

4

B

7

5

C

MONITOR
SIGNAL
GENERATING
CIRCUIT

9

D

1 0 A

1 0 B

DELAY CIRCUIT CHAIN

DELAY CIRCUIT CHAIN

2

E

8

$tV=tCK-(td1+td2)$

3;INPUT BUFFER
4;CLOCK DRIVER
5;INPUT BUFFER DUMMY
6;OUTER CLOCKS
7;INTERNAL CLOCKS
8;SYNCHRONIZATION DELAY CIRCUIT MACRO

EP 0 896 432 B1

# FIG. 22

SMDACT

OUTER CLOCKS 6

INTERNAL CLOCKS 7

MEASURING CESSATION PERIOD

MEASURING PERIOD

SYNCHRONIZATION DELAY PERIOD

BEFORE SYNCHRONIZATION

AFTER SYNCHRONIZATION

DRIVER USE TIMING

46

# FIG. 23

3;INPUT BUFFER
4;CLOCK DRIVER
5;INPUT BUFFER DUMMY
6;OUTER CLOCKS
7;INTERNAL CLOCKS
8;SYNCHRONIZATION DELAY CIRCUIT MACRO

# FIG. 24

EXTERNAL CLOCKS 6   A

MEASURING CESSATION PERIOD   D

MEASURING PERIOD SYNCHRONIZATION DELAY PERIOD   E

INTERNAL CLOCKS 7   B

  C

BEFORE SYNCHRONIZATION

AFTER SYNCHRONIZATION

$tV=tCK-(td1+td2)$

DRIVER USE TIMING

# FIG. 25

td1 | tCK

td1 | td2

906
903
A
905
B
908
C
DELAY CIRCUIT CHAIN ~901
DELAY CIRCUIT CHAIN ~902
905A
905B

DELAY CIRCUIT CHAIN ~901A
D
DOUBLE-SPEED DELAY CIRCUIT CHAIN ~902A

910A
904
SYNTHE-SIS CIRCUIT
E
td2
907

901;DELAY CIRCUIT CHAIN
902;DELAY CIRCUIT CHAIN
901A;DELAY CIRCUIT CHAIN
902A;
903;INPUT BUFFER
904;CLOCK DRIVER
905;DUMMY DELAY CIRCUIT
905A;INPUT BUFFER
905B;CLOCK DRIVER DUMMY
907;INTERNAL CLOCK
908;SYNCHRONIZATION DELAY CIRCUIT MACRO

FIG. 26

EP 0 896 432 B1

CLOCK DRIVER 904'

tCK  tCK  tCK

OUTER CLOCKS 906

A

B

td1

td1+td2

MEASURING PERIOD

SYNCHRONIZATION DELAY PERIOD  tV  tV

C

tCK  tCK/2

D

E

td2  td2

INTERNAL CLOCK 907·(DOUBLE PERIOD)

INTERNAL CLOCK 907A(Duty50)

905;DUMMY DELAY CIRCUIT

905A;INPUT BUFFER DUMMY

905B;CLOCK DRIVER DUMMY

906;OUTER CLOCKS

903;INPUT BUFFER

905;DUMMY DELAY CIRCUIT

# FIG. 27

3;INPUT BUFFER
4;CLOCK DRIVER
5;INPUT BUFFER DUMMY
6;OUTER CLOCKS
7;INTERNAL CLOCKS
8;SYNCHRONIZATION DELAY CIRCUIT MACRO
10A;SWITCH 1
10B;SWITCH 2

FIG. 28

# FIG. 29

11 ; DELAY CIRCUIT CAHIN
11a;DELAY CIRCUIT CHAIN
12;DELAY CIRCUIT CHAIN
18;CONTROL CIRCUIT

# FIG. 30

HAND FOR LOAD ADJUSTMENT

11a;DELAY CIRCUIT CHAIN
12;DELAY CIRCUIT CHAIN
18;CONTROL CIRCUIT

# FIG. 31

D

FREQUENCY DIVIDED
SIGNAL AA OF A

VCC

MP12

F1n+1

F1n

MN12

GND

11a;
DELAY CIRCUIT
CHAIN

COMPLEMENTARY SIGNAL AA
OF THE FREQUENCY DIVIDER

A

VCC   VCC

MP13    MP13a

B1n   B1n+1

MN13   MN13a

GND    GND

12;DELAY CIRCUIT CHAIN

FIG. 32

EP 0 896 432 B1

56

# FIG. 33

3;INPUT BUFFER
4;CLOCK DRIVER
5;INPUT BUFFER DUMMY
6;EXTERNAL CLOCKS
7;INTERNAL CLOCKS
8;SYNCHRONIZATION DELAY CIRCUIT MACRO
10;SWITCH